# EUROPEAN PATENT APPLICATION

(11) **EP 4 686 335 A1**
(43) Date of publication of application: **28.01.2026**
(21) Application number: 25169273.7
(22) Date of filing: 08.04.2025
(51) Int. Cl.: H10B 12/00

(54) **SEMICONDUCTOR DEVICES**

(30) Priority: 24.07.2024 KR 20240098146
(71) Applicant: Samsung Electronics Co., Ltd., Suwon-si, Gyeonggi-do 16677 (KR)
(72) Inventor: LEE, Hyunjin, 16677 Suwon-si (KR); KIM, Hui-Jung, 16677 Suwon-si (KR); KIM, Yong Kwan, 16677 Suwon-si (KR); CHAE, Heejae, 16677 Suwon-si (KR)
(74) Representative: Marks & Clerk LLP

(57) **Abstract**

A semiconductor device includes a semiconductor substrate including a horizontal portion and a vertical portion protruding upward from the horizontal portion, a bit line on the semiconductor substrate and extending in a first direction parallel to a bottom surface of the semiconductor substrate, a word line on the bit line and extending in a second direction parallel to the bottom surface of the semiconductor substrate that is different from the first direction, a semiconductor pattern on the vertical portion of the semiconductor substrate and extending in a third direction perpendicular to the bottom surface of the semiconductor substrate, and a metal silicide pattern between the semiconductor pattern and the bit line. The semiconductor pattern includes a source/drain region adjacent to the bit line and a channel region on the source/drain region, and the metal silicide pattern is in contact with the source/drain region and the bit line.

## Description

### BACKGROUND OF THE INVENTION

The present disclosure relates to a semiconductor device and a method of fabricating the same and, in particular, to a semiconductor memory device including vertical channel transistors and a method of fabricating the same.

A semiconductor device may include an integrated circuit including metal-oxide-semiconductor field-effect transistors (MOSFETs). To meet an increasing demand for a semiconductor device with a small pattern size and a reduced design rule, the MOSFETs are being aggressively scaled down. The scale-down of the MOSFETs may lead to deterioration in operational properties of the semiconductor device. A variety of studies are being conducted to overcome technical limitations caused by the scale-down of the semiconductor device and to provide a high performance semiconductor device.

### SUMMARY OF THE INVENTION

Example embodiments of the inventive concepts provide a semiconductor device, which includes vertical channel transistors with improved electric reliability, and a method of fabricating the same.

According to some embodiments of the inventive concepts, a semiconductor device includes a semiconductor substrate including a horizontal portion and a vertical portion protruding upward from the horizontal portion, a bit line on the semiconductor substrate and extending in a first direction parallel to a bottom surface of the semiconductor substrate, a word line on the bit line and extending in a second direction parallel to the bottom surface of the semiconductor substrate that is different from the first direction, a semiconductor pattern on the vertical portion of the semiconductor substrate and extending in a third direction perpendicular to the bottom surface of the semiconductor substrate, and a metal silicide pattern between the semiconductor pattern and the bit line. The semiconductor pattern includes a source/drain region adjacent to the bit line and a channel region on the source/drain region, and the metal silicide pattern is in contact with the source/drain region and the bit line.

According to some embodiments of the inventive concepts, a semiconductor device includes a semiconductor substrate including a horizontal portion and a vertical portion protruding upward from the horizontal portion, a bit line on the semiconductor substrate and extending in a first direction parallel to a bottom surface of the semiconductor substrate, a word line on the bit line and extending in a second direction parallel to the bottom surface of the semiconductor substrate that is different from the first direction, a back gate electrode spaced apart from the word line in the first direction and extending in the second direction, and a semiconductor pattern on the vertical portion of the semiconductor substrate and extending in a third direction perpendicular to the bottom surface of the semiconductor substrate. The semiconductor pattern includes a first source/drain region, a channel region, and a second source/drain region stacked in the third direction. The bit line is adjacent to a side surface of the first source/drain region in the second direction, and the channel region is between the word line and the back gate electrode.

According to some embodiments of the inventive concepts, a semiconductor device includes a semiconductor substrate including a horizontal portion and a vertical portion protruding upward from the horizontal portion, a device isolation layer on the horizontal portion of the semiconductor substrate, a bit line on the semiconductor substrate and extending in a first direction parallel to a bottom surface of the semiconductor substrate, a gapfill insulating pattern on a top surface of the bit line, a word line on the bit line and extending in a second direction parallel to the bottom surface of the semiconductor substrate that is different from the first direction, a semiconductor pattern on the vertical portion of the semiconductor substrate and extending in a third direction perpendicular to the bottom surface of the semiconductor substrate, a metal silicide pattern between the semiconductor pattern and the bit line, an upper insulating layer on the word line, an upper conductive contact extending in the upper insulating layer and electrically connected to the semiconductor pattern, and a data storage pattern electrically connected to the upper conductive contact. The semiconductor pattern includes a source/drain region adjacent to the bit line and a channel region on the source/drain region, and the metal silicide pattern is in contact with the bit line and a side surface of the source/drain region.

At least some of the above and other features of the invention are set out in the claims.

### BRIEF DESCRIPTION OF THE DRAWINGS

FIG. 1 is a block diagram illustrating a semiconductor device according to some embodiments of the inventive concepts.
FIGS. 2 and 3 are perspective views schematically illustrating a semiconductor device according to some embodiments of the inventive concepts.
FIG. 4 is a plan view illustrating a semiconductor device according to some embodiments of the inventive concepts.
FIGS. 5A to 5E are cross-sectional views taken along lines A-A', B-B', C-C', D-D', and E-E', respectively, of FIG. 4.
FIGS. 6 and 7 are cross-sectional views taken along line A-A' of FIG. 4.
FIGS. 8A and 8B are cross-sectional views taken along lines A-A' and C-C', respectively, of FIG. 4.
FIG. 9 is a plan view illustrating a semiconductor device according to some embodiments of the inventive concepts.
FIG. 10 is a cross-sectional view taken along line E-E' of FIG. 9.
FIG. 11 is a plan view illustrating a semiconductor device according to some embodiments of the inventive concepts.
FIGS. 12A to 12C are cross-sectional views taken along lines C-C', D-D', and E-E', respectively, of FIG. 11.
FIG. 13 is a plan view illustrating a semiconductor device according to some embodiments of the inventive concepts.
FIGS. 14A and 14B are cross-sectional views taken along lines A-A' and E-E', respectively, of FIG. 13.
FIGS. 15 to 17 are plan views illustrating a semiconductor device according to some embodiments of the inventive concepts.
FIG. 18 is a plan view illustrating a semiconductor device according to some embodiments of the inventive concepts.
FIG. 19 is a cross-sectional view taken along line F-F' of FIG. 18.
FIG. 20 is a plan view illustrating a semiconductor device according to some embodiments of the inventive concepts.
FIGS. 21, 22A, 22B, 23, 24A, 24B, 24C, 24D, 24E, 25, 26A, 26B, 26C, 27, 28A, 28B, 28C, 28D, 28E, 29, 30A, 30B, 30C, 30D, and 30E are diagrams illustrating a method of fabricating a semiconductor device, according to some embodiments of the inventive concepts.

### DETAILED DESCRIPTION

Example embodiments of the inventive concepts will now be described more fully with reference to the accompanying drawings, in which example embodiments are shown.

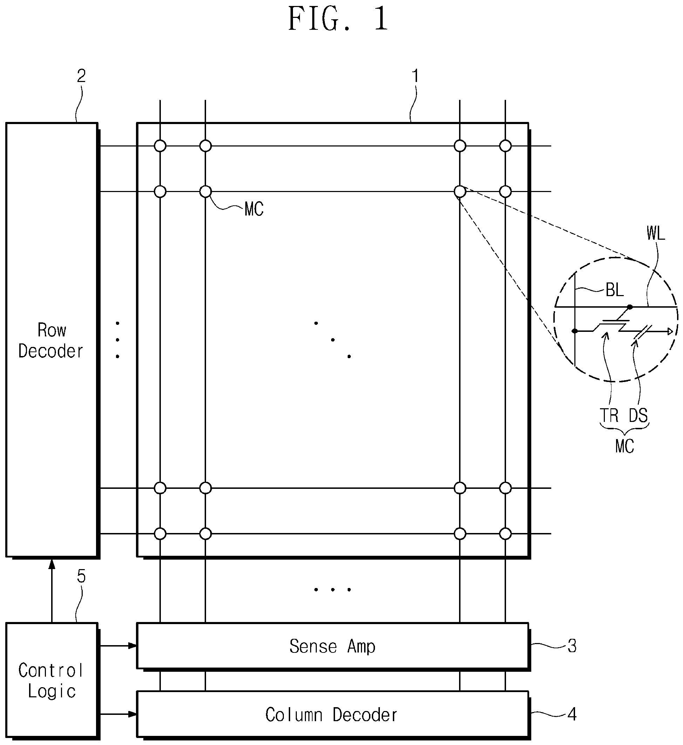

FIG. 1 is a block diagram illustrating a semiconductor device according to some embodiments of the inventive concepts.

Referring to FIG. 1, a semiconductor device may include a memory cell array 1, a row decoder 2, a sense amplifier 3, a column decoder 4, and a control logic 5.

The memory cell array 1 may include a plurality of memory cells MC, which are two- or three-dimensionally arranged. Each of the memory cells MC may be disposed between and connected to a word line WL and a bit line BL crossing each other. Each of the memory cells MC may include a selection element TR and a data storing element DS. The selection element TR and the data storing element DS may be electrically connected to each other. The selection element TR may be connected to the word line WL and the bit line BL and may be provided at an intersection point between the word line WL and the bit line BL.

The selection element TR may include a field effect transistor. The data storing element DS may include a capacitor, a magnetic tunnel junction pattern, or a variable resistor. In the case where the selection element TR includes the field effect transistor, a gate terminal of the field effect transistor may be connected to the word line WL, and source/drain terminals of the field effect transistor may be connected to the bit line BL and the data storing element DS, respectively.

The row decoder 2 may be configured to decode address information, which is input from the outside (e.g., from an external source such as a memory controller), and to select one of the word lines WL of the memory cell array 1, based on the decoded address information. The address information decoded by the row decoder 2 may be provided to a row driver (not shown), and in this case, the row driver may provide respective voltages to the selected one of the word lines WL and the unselected ones of the word lines WL, in response to the control of a control circuit.

The sense amplifier 3 may be configured to sense, amplify, and output a voltage difference between one of the bit lines BL, which is selected based on address information decoded by the column decoder 4, and a reference bit line.

The column decoder 4 may provide a data transmission path between the sense amplifier 3 and an external device (e.g., a memory controller). The column decoder 4 may be configured to decode address information, which is input from the outside, and to select one of the bit lines BL of the memory cell array 1, based on the decoded address information. The control logic 5 may generate control signals, which are used to control an operation of writing or reading data to or from the memory cell array 1.

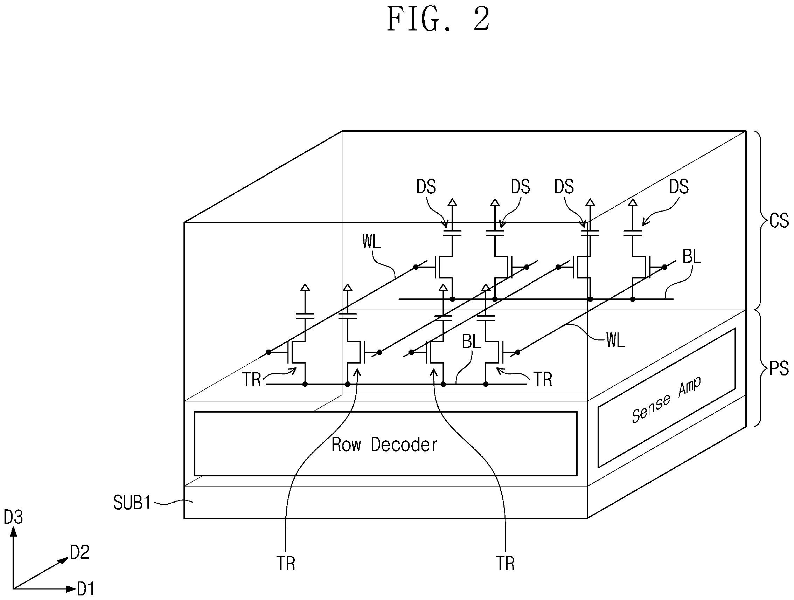

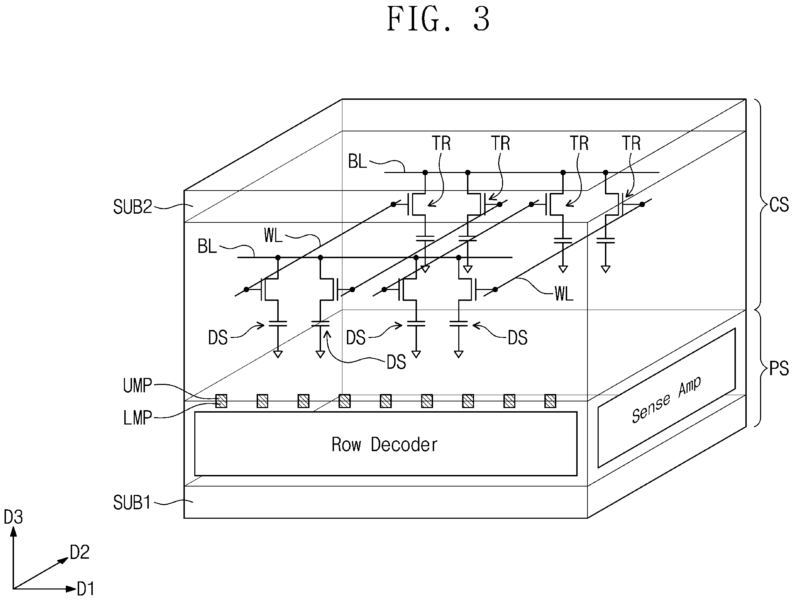

FIGS. 2 and 3 are perspective views schematically illustrating a semiconductor device according to some embodiments of the inventive concepts.

Referring to FIG. 2, the semiconductor device may include a first substrate SUB1, a peripheral circuit structure PS on the first substrate SUB1, and a cell array structure CS on the peripheral circuit structure PS. Hereinafter, a first direction D1 and a second direction D2 may be parallel to a top surface and/or a bottom surface of the first substrate SUB1 and may not be parallel to each other (i.e., may be different from each other), and a third direction D3 may be perpendicular to the top surface and/or the bottom surface of the first substrate SUB1. The peripheral circuit structure PS and the cell array structure CS may be stacked on the first substrate SUB1 in the third direction D3.

The peripheral circuit structure PS may include core and peripheral circuits, which are formed on the first substrate SUB1. The core and peripheral circuits may include the row and column decoders 2 and 4, the sense amplifier 3, and the control logic 5 described with reference to FIG. 1.

The cell array structure CS may include the memory cell array 1 of FIG. 1, which includes the memory cells MC of FIG. 1 that are two-dimensionally or three-dimensionally arranged. In some embodiments, the selection element TR of each of the memory cells MC (e.g., see FIG. 1) may include a vertical channel transistor (VCT). The vertical channel transistor may include a channel pattern, which is elongated in the third direction D3.

Referring to FIG. 2, the peripheral circuit structure PS may be disposed between the first substrate SUB1 and the cell array structure CS and may be electrically connected to the cell array structure CS through conductive contacts.

In some embodiments, although not shown in FIG. 2, the peripheral circuit structure PS may be disposed on the first substrate SUB1 and the cell array structure CS. For example, the cell array structure CS may be disposed on the first substrate SUB1, and the peripheral circuit structure PS may be disposed on the cell array structure CS. The cell array structure CS and the peripheral circuit structure PS may be electrically connected to each other through conductive contacts.

Referring to FIG. 3, in some embodiments, the semiconductor device may have a chip-to-chip (C2C) bonding structure. In more detail, the peripheral circuit structure PS may be provided on the first substrate SUB1, and first metal pads LMP may be disposed in an upper portion of the peripheral circuit structure PS. The first metal pads LMP may be electrically connected to the core and peripheral circuits. The cell array structure CS may be provided on a second substrate SUB2. Second metal pads UMP may be provided in a lower portion of the cell array structure CS. The second metal pads UMP may be electrically connected to the memory cell array (e.g., see the memory cell array 1 of FIG. 1). The first metal pads LMP in the peripheral circuit structure PS may be directly bonded to the second metal pads UMP of the cell array structure CS. The peripheral circuit structure PS and the cell array structure CS may be electrically connected to each other through the first and second metal pads LMP and UMP.

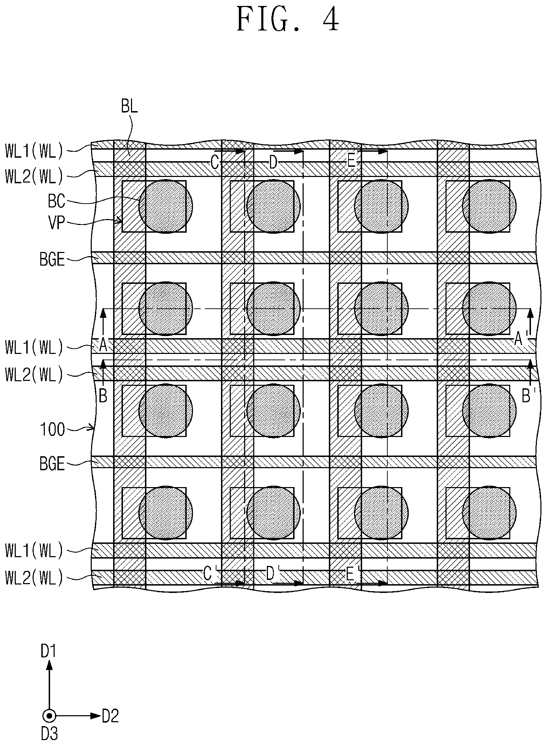

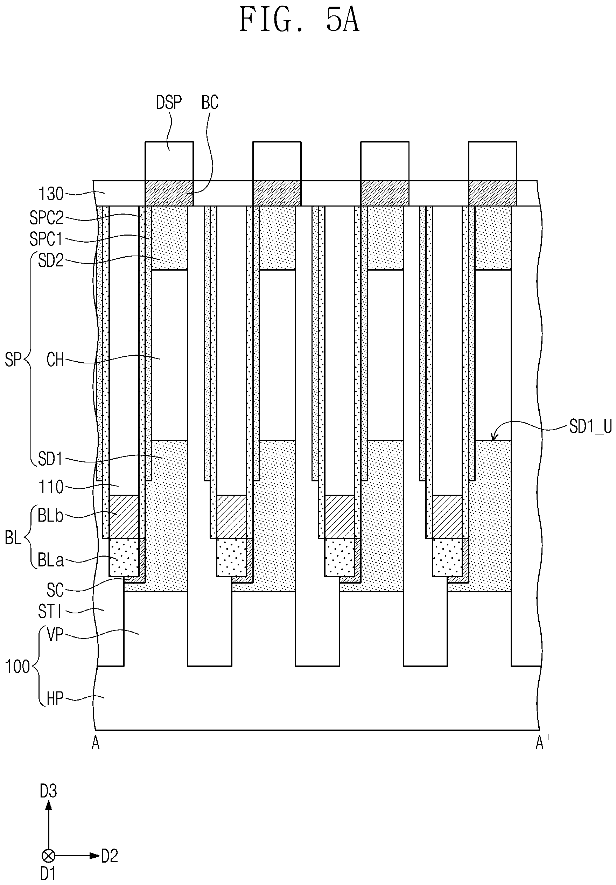

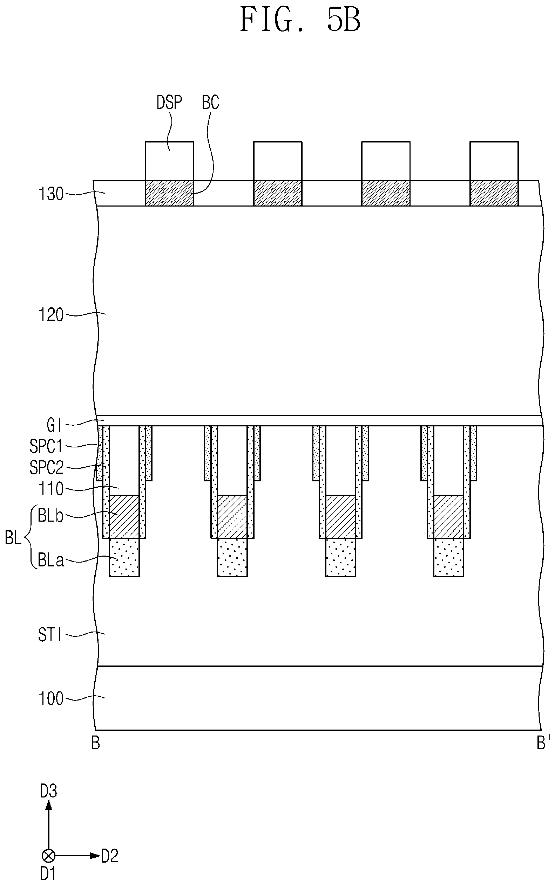

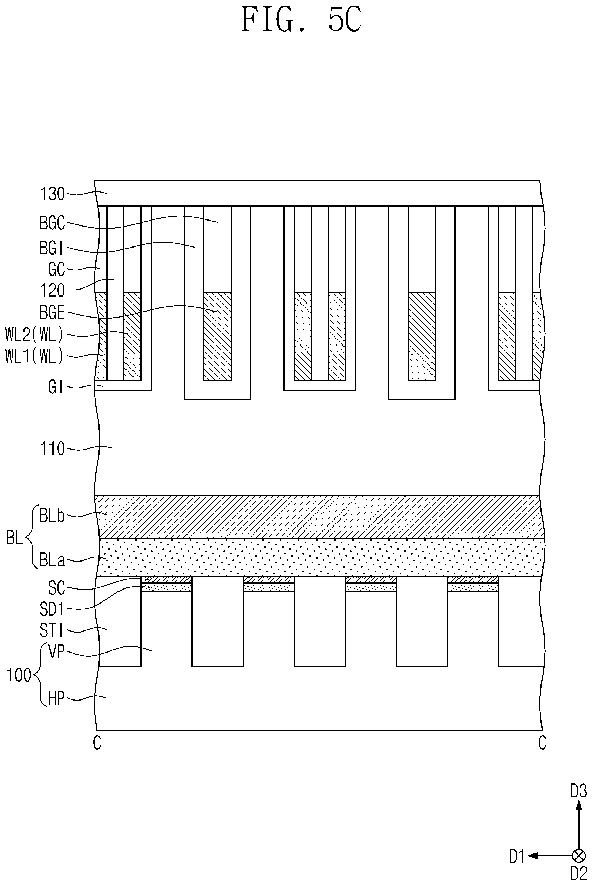

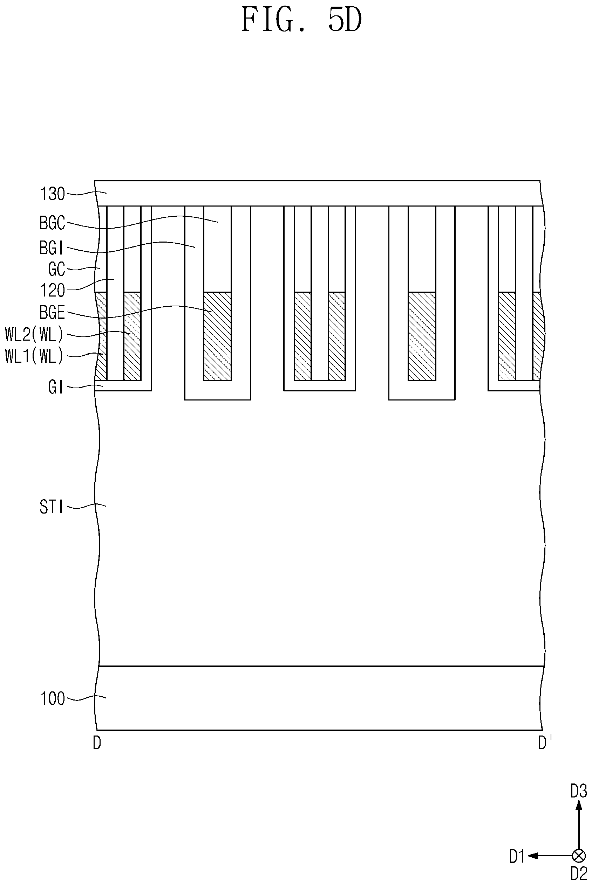

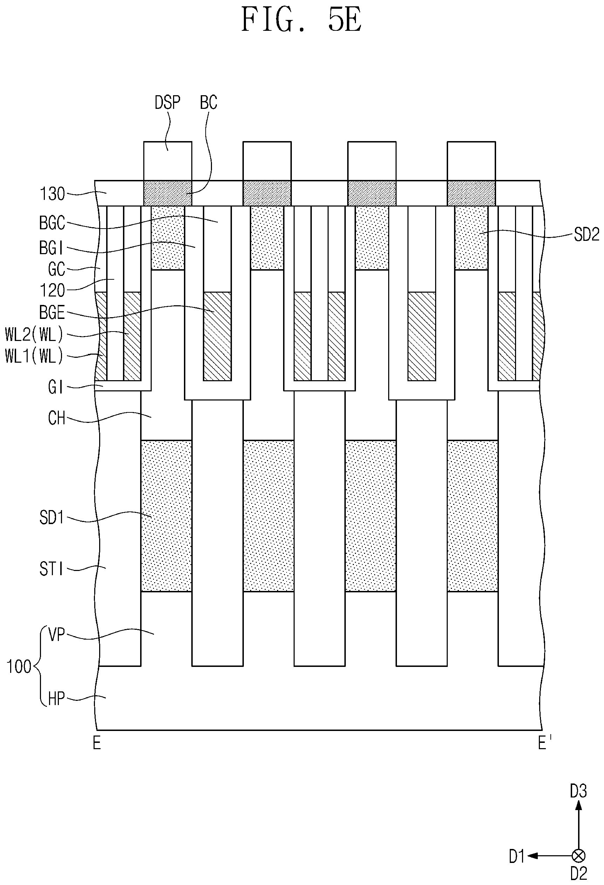

FIG. 4 is a plan view illustrating a semiconductor device according to some embodiments of the inventive concepts. FIGS. 5A to 5E are cross-sectional views taken along lines A-A', B-B', C-C', D-D', and E-E', respectively, of FIG. 4.

Referring to FIG. 4 and FIGS. 5A to 5E, the cell array structure CS described with reference to FIGS. 2 and 3 may be disposed on a semiconductor substrate 100. According to some embodiments of the inventive concepts, the semiconductor substrate 100 may include the first substrate SUB1 and the peripheral circuit structure PS described with reference to FIG. 2 and may further include an insulating layer on (e.g., covering or overlapping) the peripheral circuit structure PS. The cell array structure CS may be disposed on the insulating layer. In some embodiments, the semiconductor substrate 100 may include the second substrate SUB2 described with reference to FIG. 3 and may further include an insulating layer on the second substrate SUB2. The cell array structure CS may be disposed on the insulating layer.

The semiconductor substrate 100 includes a horizontal portion HP and may include vertical portions VP, which are provided on the horizontal portion HP and are protruded in a vertical direction (or the third direction D3). For example, the vertical portions VP may protrude upward, beyond the horizontal portion HP in the third direction D3. In some embodiments, each of the vertical portions VP may have a rectangular shape, when viewed in a plan view. The vertical portions VP may be spaced apart from each other in the first and second directions D1 and D2. The horizontal portion HP may be extended in the first and second directions D1 and D2 and may be connected to the vertical portions VP, which are spaced apart from each other. In some embodiments, the semiconductor substrate 100 may be a silicon substrate. In the present specification, the first and second directions D1 and D2 are parallel to a bottom surface of the semiconductor substrate 100, and the third direction D3 is perpendicular to the bottom surface of the semiconductor substrate 100.

A device isolation layer STI, which is disposed between the vertical portions VP, may be provided on the horizontal portion HP. The vertical portions VP may be spaced apart from each other with the device isolation layer STI interposed therebetween. The device isolation layer STI may include at least one of insulating materials (e.g., silicon oxide or silicon nitride). The device isolation layer STI may be a single layer, which is made of a single material, or a composite layer including two or more materials.

Semiconductor patterns SP may be disposed on the vertical portions VP. Each of the semiconductor patterns SP may be a vertical semiconductor pattern that is elongated in a vertical direction (or the third direction D3). In other words, each of the semiconductor patterns SP may extend in the third direction D3. The semiconductor patterns SP may be spaced apart from each other in the first and second directions D1 and D2. Each of the semiconductor patterns SP may include a first source/drain region SD1, a channel region CH, and a second source/drain region SD2, which are sequentially disposed (i.e., sequentially stacked) in the third direction D3. The channel region CH may be provided between the first and second source/drain regions SD1 and SD2. A width of the first source/drain region SD1 may vary depending on a vertical distance from the semiconductor substrate 100. For example, the width of the first source/drain region SD1 may decrease as a distance from the semiconductor substrate 100 in the third direction D3 increases.

The semiconductor patterns SP include a semiconductor material. In some embodiments, the semiconductor patterns SP may be formed of, or include, at least one of silicon (e.g., single crystalline silicon), germanium, or silicon germanium. The first and second source/drain regions SD1 and SD2 may further include dopants. The first and second source/drain regions SD1 and SD2 may have the same conductivity type and may be impurity regions doped with n- or p-type dopants. The dopant concentration in the first and second source/drain regions SD1 and SD2 may be higher than the dopant concentration in the channel region CH.

The bit lines BL are disposed on the semiconductor substrate 100. The bit lines BL extend in the first direction D1, on the vertical portions VP, and may be spaced apart from each other in the second direction D2. The bit lines BL may be respectively disposed between the semiconductor patterns SP. Each of the bit lines BL may include a first bit line BLa and a second bit line BLb stacked on the first bit line BLa. In some embodiments, the first bit line BLa may include a conductive metal nitride including a first metal element (i.e., a first metal material) and may further include a doped semiconductor material (e.g., doped silicon and/or doped germanium). For example, the first metal element may be at least one of Ti, Mo, W, Cu, Al, Ta, Ru, Ir, or Co. In some embodiments, the second bit line BLb may include a second metal element (e.g., Ti, Mo, W, Cu, Al, Ta, Ru, Ir, Co, or the like) and may further include a conductive metal nitride material (e.g., including Ti, Mo, W, Cu, Al, Ta, Ru, Ir, or Co).

The bit lines BL may face a side surface of the first source/drain region SD1 of the semiconductor pattern SP. For example, the bit line BL may be adjacent to the side surface of the first source/drain region SD1 in the second direction D2. A top surface of the bit line BL may be located at a level lower (e.g., in the third direction D3) than the uppermost end SD1_U of the first source/drain region SD1 (e.g., relative to the bottom surface of the semiconductor substrate 100). In other words, a top surface of the second bit line BLb may be located at a level lower than the uppermost end SD1_U of the first source/drain region SD1. For example, a first distance in the third direction D3 between the bottom surface of the semiconductor substrate 100 and the top surface of the bit line BL may be less than a second distance in the third direction D3 between the bottom surface of the semiconductor substrate 100 and the uppermost end SD1_U of the first source/drain region SD1.

A metal silicide pattern SC may be disposed between the bit line BL and the first source/drain region SD1 adjacent thereto. Each of the metal silicide patterns SC may be disposed between the semiconductor pattern SP and the bit line BL and may be in contact with a side surface of the semiconductor pattern SP. The metal silicide pattern SC may be in contact with the side and bottom surfaces of the first bit line BLa and the side surface of the first source/drain region SD1. In some embodiments, the metal silicide pattern SC may be in contact with the device isolation layer STI. The metal silicide patterns SC may be spaced apart from each other in the first and second directions D1 and D2.

The metal silicide pattern SC may include the first metal element and silicon. In other words, the metal silicide pattern SC and the first bit line BLa may include the same metal element (e.g., the first metal element).

A gapfill insulating pattern 110 may be disposed on the bit line BL. The gapfill insulating pattern 110 may be on (e.g., may cover or overlap) the top surface of the bit line BL. In some embodiments, the gapfill insulating pattern 110 may include a silicon-based insulating material. As used herein, "an element A overlaps an element B in a direction X" (or similar language) means that there is at least one straight line that extends in the direction X and intersects both the elements A and B.

First and second spacers SPC1 and SPC2 may be disposed on side surfaces of the bit line BL and the gapfill insulating pattern 110. In more detail, a side surface of the second spacer SPC2 may be in contact with the side surface of the second bit line BLb and the side surface of the gapfill insulating pattern 110 in the second direction D2, and the first spacer SPC1 may be disposed on an opposite side surface of the second spacer SPC2. In other words, the first spacer SPC1 may be disposed between the second spacer SPC2 and the semiconductor pattern SP and may be spaced apart from the bit line BL.

The first spacer SPC1 may be in contact with the first source/drain region SD1, the channel region CH, and the second source/drain region SD2. The second spacer SPC2 may be in contact with the first spacer SPC1 and the first source/drain region SD1. In some embodiments, the first and second spacers SPC1 and SPC2 may include silicon oxide, silicon nitride, and/or silicon oxynitride.

The word lines WL may be disposed on the bit lines BL, the gapfill insulating pattern 110, and the device isolation layer STI and may cross the bit lines BL. The word lines WL may be extended in the second direction D2 and may be spaced apart from each other in the first direction D1. Back gate electrodes BGE may be disposed on the gapfill insulating pattern 110 and the device isolation layer STI and over the bit lines BL to cross the bit lines BL. The back gate electrodes BGE may be extended in the second direction D2 and may be spaced apart from each other in the first direction D1. The word lines WL and the back gate electrodes BGE may be spaced apart from each other in the first direction D1.

Each of the semiconductor patterns SP may be disposed between a corresponding one of the word lines WL and a corresponding one of the back gate electrodes BGE. In more detail, the channel region CH of the semiconductor pattern SP may be located between a corresponding pair of the word line WL and the back gate electrode BGE.

A gate insulating pattern GI may be interposed between the semiconductor pattern SP and each of the word lines WL and may be extended in the second direction D2. A back gate insulating pattern BGI may be interposed between the semiconductor pattern SP and each of the back gate electrodes BGE and may be extended in the second direction D2.

A pair of word lines WL or the back gate electrode BGE may be disposed between the semiconductor patterns SP, which are adjacent to each other in the first direction D1. The pair of word lines WL may include a first word line WL1 and a second word line WL2. The first and second word lines WL1 and WL2 may be provided to face each pair of the semiconductor patterns SP, respectively, which are placed at both (i.e., opposing) sides of them. In other words, the channel region CH of the semiconductor pattern SP corresponding to the first word line WL1 may be controlled by the first word line WL1, and the channel region CH of the semiconductor pattern SP corresponding to the second word line WL2 may be controlled by the second word line WL2.

The back gate electrode BGE may apply a voltage to the semiconductor patterns SP, which are adjacent thereto in the first direction D1. The applied voltage may be used to adjust a threshold voltage of the transistor including the semiconductor pattern SP, and thus, the transistor may be normally operated.

A separation insulating pattern 120 may be interposed between the pair of word lines WL1 and WL2 and may be extended in the second direction D2. The pair of word lines WL1 and WL2 may be electrically separated from each other by the separation insulating pattern 120.

The word lines WL and the back gate electrodes BGE may include a conductive material and they may include at least one of, for example, metallic materials (e.g., Ti, Mo, W, Cu, Al, Ta, Ru, Ir, and/or Co), metal silicide materials (e.g., silicide materials including Ti, Mo, W, Cu, Al, Ta, Ru, Ir, and/or Co), or conductive metal nitride materials (e.g., nitride materials including Ti, Mo, W, Cu, Al, Ta, Ru, Ir, and/or Co). The gate insulating pattern GI, the back gate insulating pattern BGI, and the separation insulating pattern 120 may include at least one of insulating materials (e.g., silicon oxide, silicon nitride, and/or silicon oxynitride).

A gate capping pattern GC may be disposed on each of the word lines WL. The word line WL and the gate capping pattern GC may be sequentially stacked in the third direction D3 at an end of the semiconductor pattern SP. A back gate capping pattern BGC may be disposed on each of the back gate electrodes BGE. The back gate electrode BGE and the back gate capping pattern BGC may be sequentially stacked in the third direction D3 at an opposite end of the semiconductor pattern SP. That is, the semiconductor pattern SP may be disposed between the back gate capping pattern BGC and the gate capping pattern GC. In more detail, the second source/drain region SD2 may be located between the back gate capping pattern BGC and the gate capping pattern GC.

An upper insulating layer 130 may be disposed on the gate capping pattern GC, the back gate capping pattern BGC, and the separation insulating pattern 120. The upper insulating layer 130 may be on (e.g., may cover or overlap) top surfaces of the gate capping pattern GC, the back gate capping pattern BGC, and the separation insulating pattern 120. In some embodiments, the upper insulating layer 130 may include at least one of silicon oxide or silicon nitride.

Upper conductive contacts BC may be disposed in the upper insulating layer 130. The upper conductive contacts BC may be disposed on the semiconductor patterns SP, respectively, and may be spaced apart from each other in the first and second directions D1 and D2. The upper conductive contacts BC may be connected to the semiconductor patterns SP, respectively. Each of the upper conductive contacts BC may be provided to penetrate (i.e., extend in) the upper insulating layer 130 and may be connected to the second source/drain region SD2 of each of the semiconductor patterns SP. The upper conductive contacts BC may include a conductive material, and it may include at least one of, for example, doped semiconductor materials (e.g., doped silicon and/or doped germanium), metallic materials (e.g., Ti, Mo, W, Cu, Al, Ta, Ru, Ir, and/or Co), metal silicide materials (e.g., silicide materials including Ti, Mo, W, Cu, Al, Ta, Ru, Ir, and/or Co), or conductive metal nitride materials (e.g., nitride materials including Ti, Mo, W, Cu, Al, Ta, Ru, Ir, and/or Co).

Data storage patterns DSP may be disposed on the upper conductive contacts BC, respectively, and may be spaced apart from each other in the first and second directions D1 and D2. The data storage patterns DSP may be electrically connected to the second source/drain regions SD2 of the semiconductor patterns SP, respectively, through the upper conductive contacts BC. The first source/drain region SD1 of each of the semiconductor patterns SP may be electrically connected to a corresponding one of the bit lines BL through the metal silicide pattern SC.

In some embodiments, each of the data storage patterns DSP may be a capacitor including a bottom electrode, a top electrode, and a dielectric layer therebetween. In this case, the semiconductor device may be a dynamic random-access memory (DRAM) device. In some other embodiments, each of the data storage patterns DSP may be a magnetic tunnel junction pattern, and in this case, the semiconductor device may be a magnetic random-access memory (MRAM) device. In some further embodiments, each of the data storage patterns DSP may include a phase-change material or a variable resistance material, and in this case, the semiconductor device may be a phase-change random-access memory (PRAM) device or a resistive random-access memory (ReRAM) device. However, the inventive concepts are not limited to these examples, and the data storage pattern DSP may include various structures and/or materials which can be used to store data.

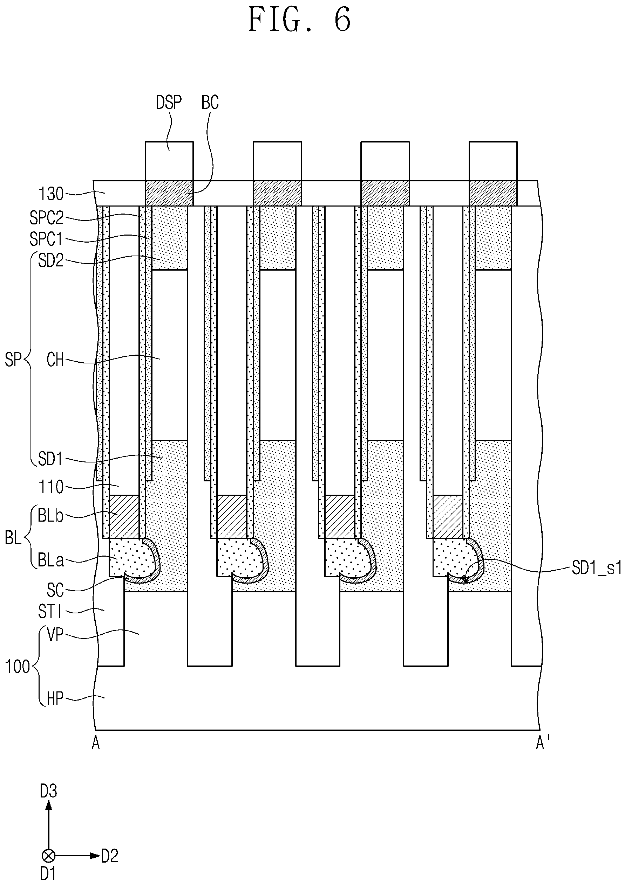

Hereinafter, semiconductor devices according to some further embodiments of the inventive concepts will be described in more detail with reference to FIGS. 6, 7, 8A, 8B, 9, 10, 11, 12A, 12B, 12C, 13, 14A, 14B, 15, 16, 17, 18, 19, and 20. In the following description, a previouslydescribed element may be identified by the same reference number without repeating an overlapping description thereof, for concise description.

FIG. 6 is a cross-sectional view taken along line A-A' of FIG. 4.

Referring to FIGS. 4 and 6, the first source/drain region SD1 may have a rounded side surface SD1_s1. In other words, the side surface of the first source/drain region SD1 in contact with the metal silicide pattern SC may have a rounded or curved shape (e.g., an inward recessed shape), unlike the structure described with reference to FIGS. 5A to 5D. For example, the rounded side surface SD1_s1 of the first source/drain region SD1 may be concavely rounded away from the bit line BL.

Similarly, the metal silicide pattern SC in contact with the first source/drain region SD1 may also have a rounded or curved shape, and in this case, a surface area of the metal silicide pattern SC may be increased. Thus, a contact area between the bit line BL and the metal silicide pattern SC may be increased, and this may make it possible to increase an operation speed of the transistors.

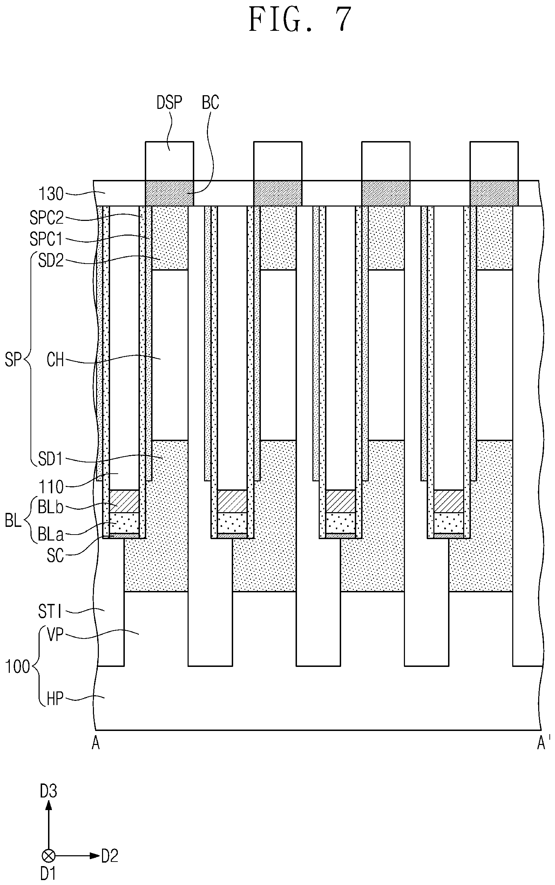

FIG. 7 is a cross-sectional view taken along line A-A' of FIG. 4.

Referring to FIGS. 4 and 7, the metal silicide pattern SC may not be in contact with the side surface of the first source/drain region SD1. When viewed in a plan view, the metal silicide pattern SC may have a plate shape and may be partially overlapped with the gapfill insulating pattern 110 (e.g., in the third direction D3). A bottom surface of the metal silicide pattern SC may be in contact with the first source/drain region SD1 and the device isolation layer STI. A side surface of the metal silicide pattern SC may be in contact with the second spacer SPC2 in the second direction D2.

The first bit line BLa may be disposed on the metal silicide pattern SC and may be spaced apart from the device isolation layer STI. Opposite side surfaces of the first bit line BLa may be in contact with the second spacer SPC2.

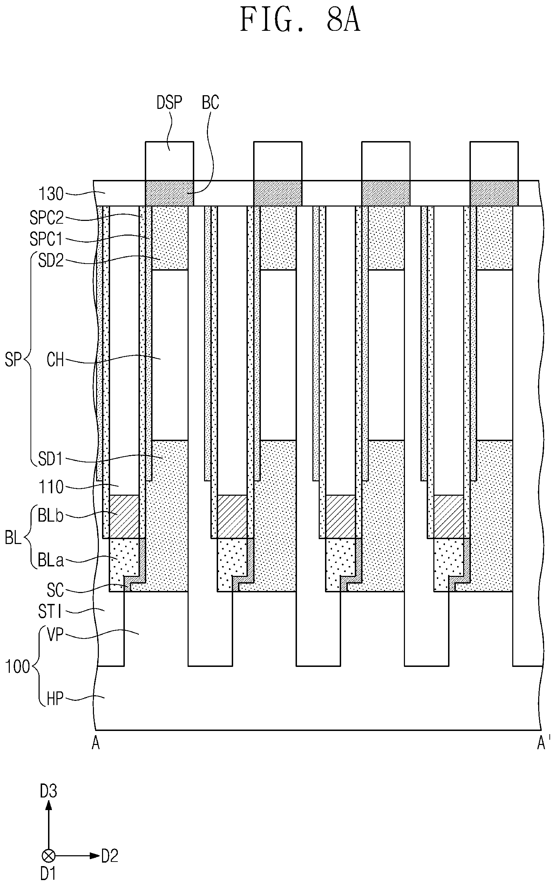

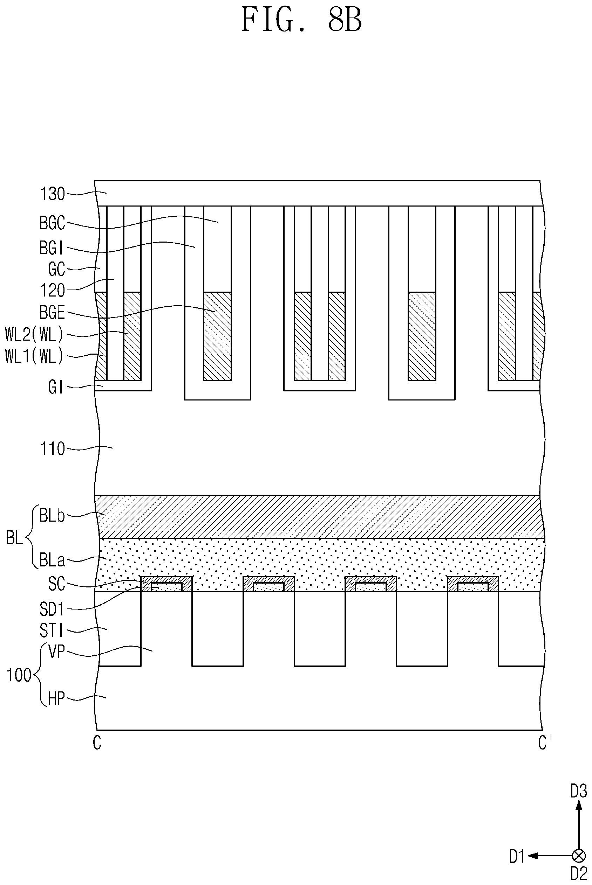

FIGS. 8A and 8B are cross-sectional views taken along lines A-A' and C-C', respectively, of FIG. 4.

Referring to FIGS. 4, 8A, and 8B, the metal silicide pattern SC may be provided to be on (e.g., to cover or overlap) the side surface of the first source/drain region SD1 and may be extended to be in contact with the vertical portion VP of the semiconductor substrate 100. The metal silicide pattern SC may be connected to (e.g., may be in contact with) a bottom end of the second spacer SPC2 to be on (e.g., to cover or overlap) a portion of the side surface of the first source/drain region SD1, which is not covered with the second spacer SPC2.

The metal silicide pattern SC may conformally extend on (e.g., may conformally cover) a portion of the first source/drain region SD1, which is not overlapped with the channel region CH (e.g., in the third direction D3) and protrudes in the second direction D2 when viewed in a plan view. The metal silicide pattern SC may be on (e.g., may cover or overlap) top and side surfaces of the protruding portion of the first source/drain region SD1.

The first bit line BLa may be on (e.g., may cover or overlap) a side surface of the metal silicide pattern SC. The metal silicide pattern SC may be spaced apart from the device isolation layer STI.

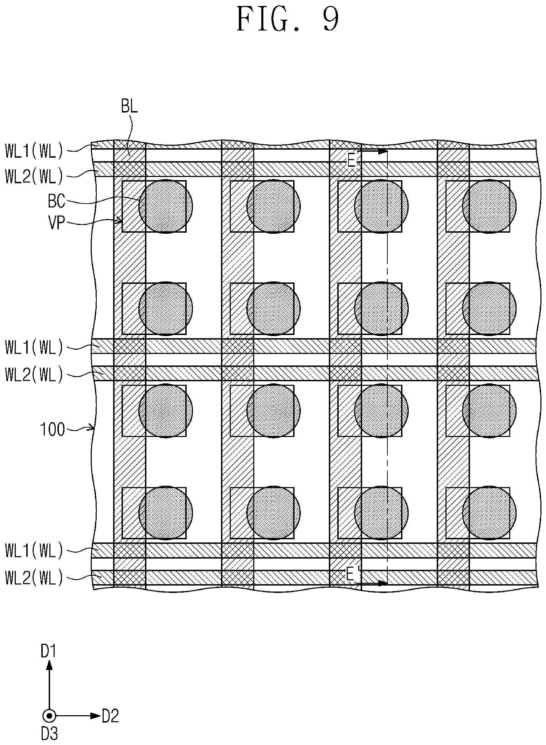

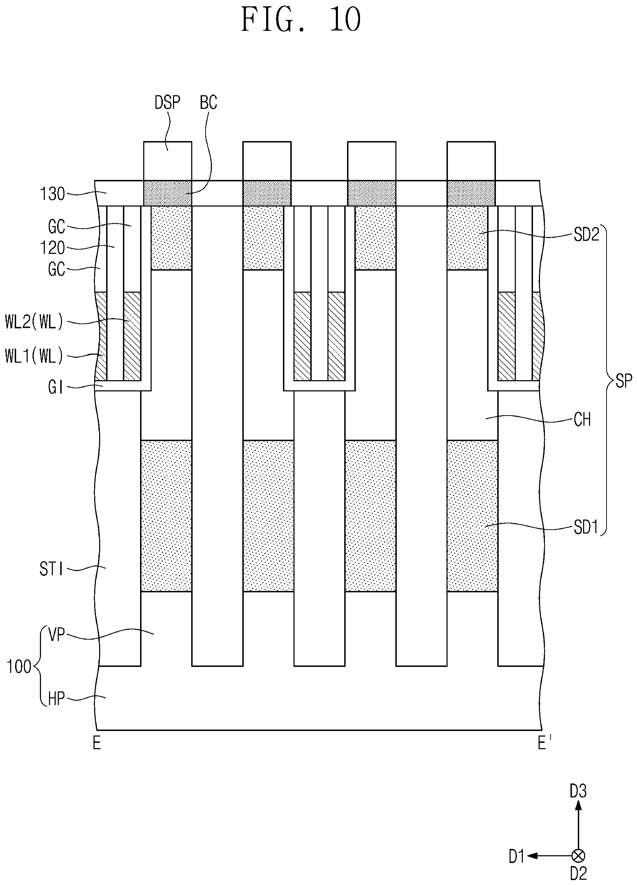

FIG. 9 is a plan view illustrating a semiconductor device according to some embodiments of the inventive concepts. FIG. 10 is a cross-sectional view taken along line E-E' of FIG. 9.

Referring to FIGS. 9 and 10, the back gate electrode BGE described with reference to FIGS. 4 and 5A to 5D may be omitted. For example, a pair of word lines WL1 and WL2 may be disposed between the semiconductor patterns SP, which are adjacent to each other in the first direction D1, or a space between the semiconductor patterns SP may be filled with the device isolation layer STI. The pair of word lines WL may include the first word line WL1 and the second word line WL2.

The first word line WL1 or the second word line WL2 may be disposed on a side surface of the semiconductor pattern SP, and the device isolation layer STI may be disposed on an opposite side surface of the semiconductor pattern SP. In other words, the first and second word lines WL1 and WL2 may be provided to face each pair of the semiconductor patterns SP, respectively, which are placed at both sides of them in the first direction D1.

The channel region CH of the semiconductor pattern SP corresponding to the first word line WL1 may be controlled by the first word line WL1, and the channel region CH of the semiconductor pattern SP corresponding to the second word line WL2 may be controlled by the second word line WL2.

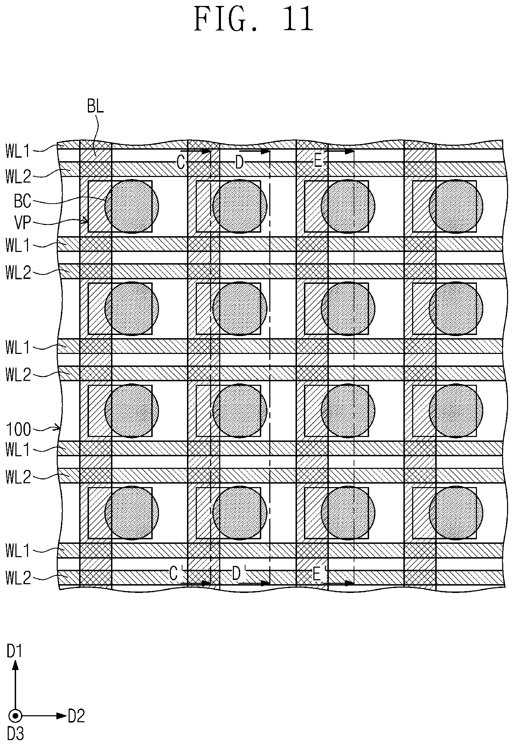

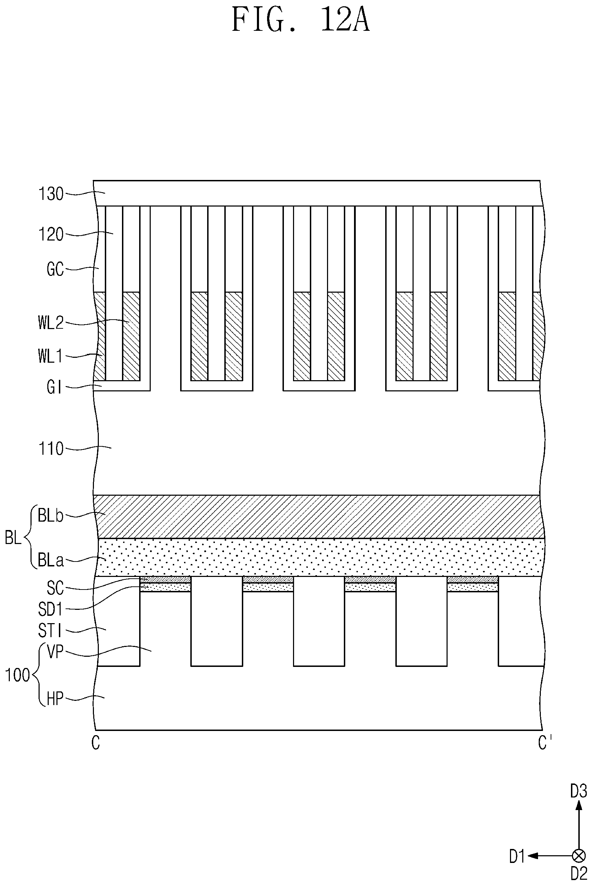

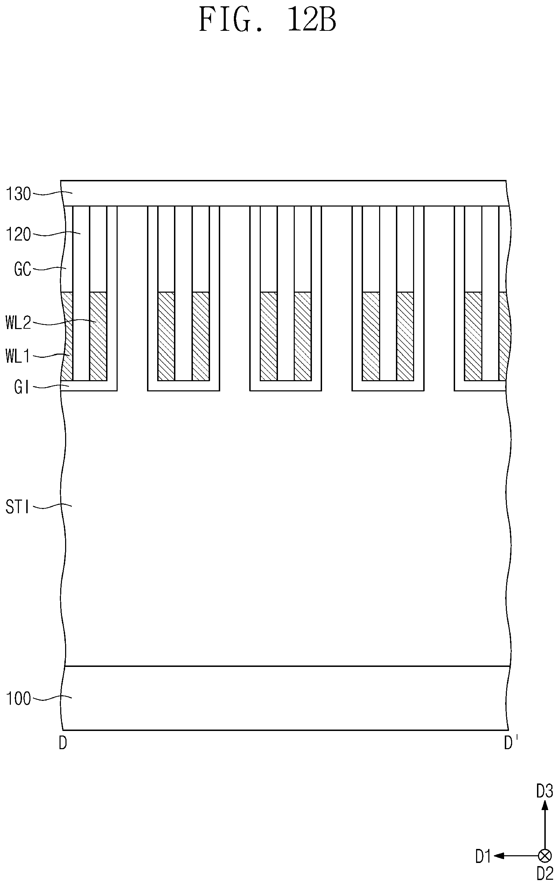

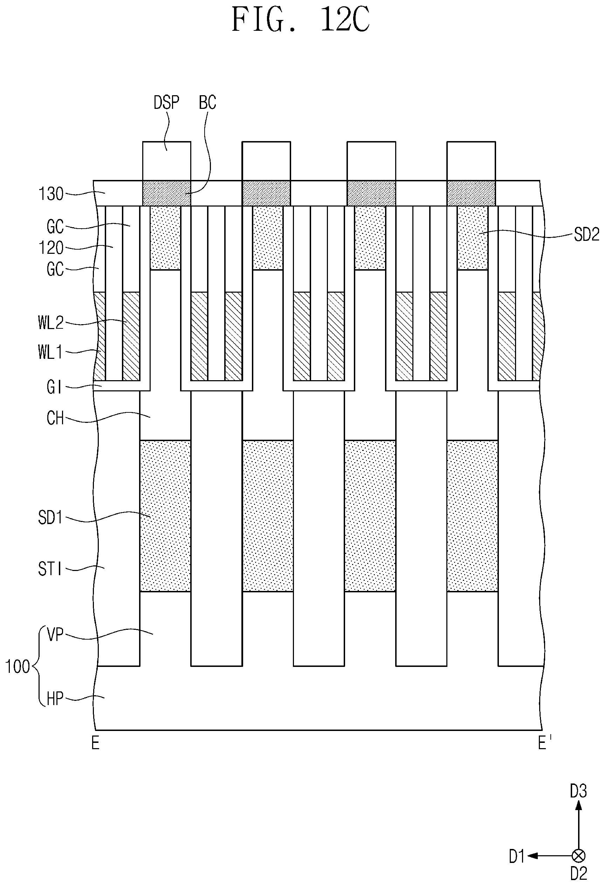

FIG. 11 is a plan view illustrating a semiconductor device according to some embodiments of the inventive concepts. FIGS. 12A to 12C are cross-sectional views taken along lines C-C', D-D', and E-E', respectively, of FIG. 11.

Referring to FIGS. 11 and 12A to 12C, the back gate electrode BGE described with reference to FIGS. 4 and 5A to 5D may be omitted, and the word lines WL1 and WL2 may be additionally provided. For example, a pair of word lines WL1 and WL2 may be disposed between the semiconductor patterns SP, which are adjacent to each other in the first direction D1. The pair of word lines WL may include the first word line WL1 and the second word line WL2.

The first word line WL1 may be disposed on a side surface of the semiconductor pattern SP, and the second word line WL2 may be disposed on an opposite side surface of the semiconductor pattern SP. That is, the first and second word lines WL1 and WL2 may be disposed at both sides of the semiconductor pattern SP. The first and second word lines WL1 and WL2, which are disposed at both sides of the semiconductor pattern SP, may be used to control the channel region CH of the semiconductor pattern SP.

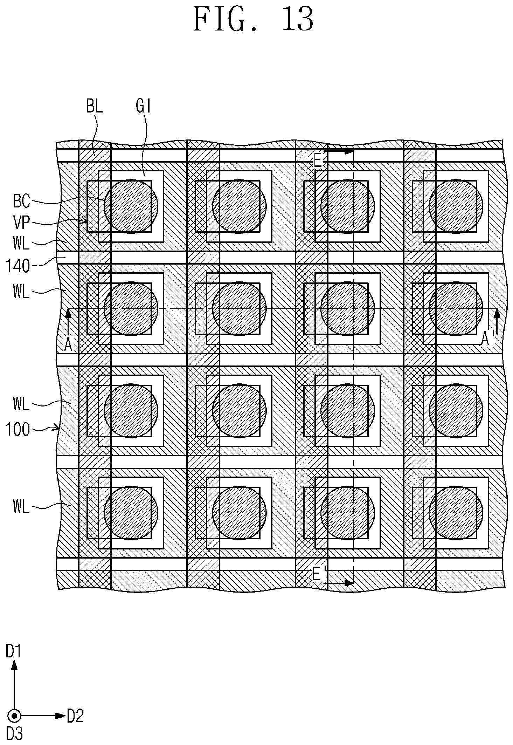

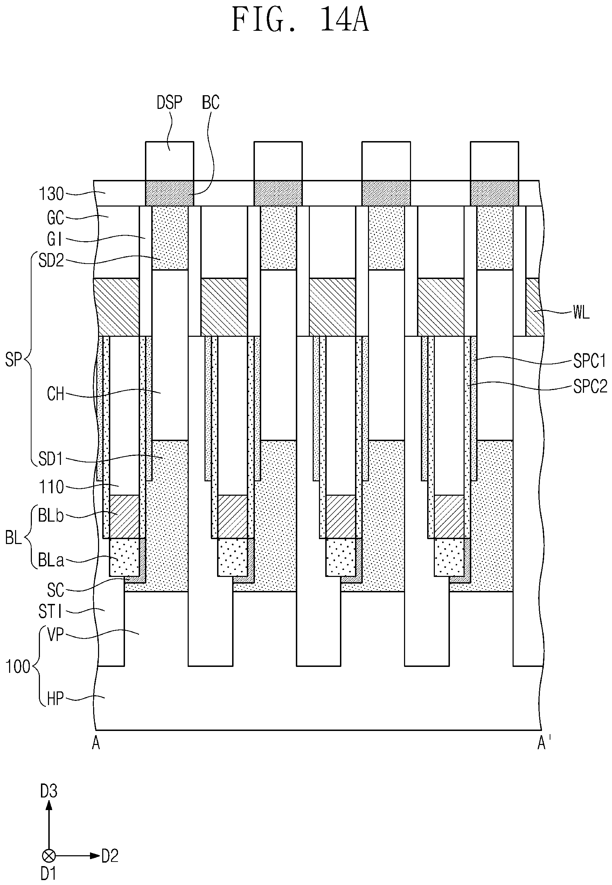

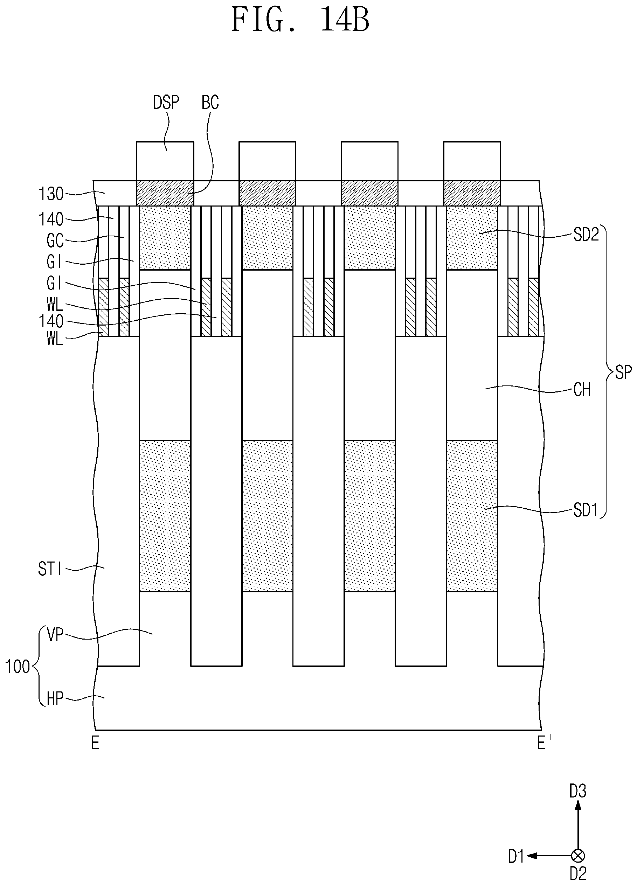

FIG. 13 is a plan view illustrating a semiconductor device according to some embodiments of the inventive concepts. FIGS. 14A and 14B are cross-sectional views taken along lines A-A' and E-E', respectively, of FIG. 13.

Referring to FIGS. 13, 14A, and 14B, the gate insulating pattern GI and the word line WL may be provided to surround a portion of the semiconductor pattern SP. For example, the gate insulating pattern GI may be provided to enclose a portion of the channel region CH and the second source/drain region SD2. The word line WL may be extended in the second direction D2 and may surround a side surface of the gate insulating pattern GI. The word line WL may be in contact with top surfaces of the gapfill insulating pattern 110, the first and second spacers SPC1 and SPC2, and the device isolation layer STI. As used herein, "an element A surrounds an element B" (or similar language) means that the element A is at least partially around the element B but does not necessarily mean that the element A completely encloses the element B.

The gate capping pattern GC may be disposed on the word line WL. The gate capping pattern GC on the word line WL may face a side surface of the gate insulating pattern GI.

The word lines WL may be extended in the second direction D2 and may be spaced apart from each other in the first direction D1. A second separation insulating pattern 140 may be disposed between the word lines WL, which are adjacent to each other in the first direction D1. In some embodiments, the second separation insulating pattern 140 may include at least one of silicon oxide or silicon nitride.

The upper insulating layer 130 may be disposed on the gate capping pattern GC, the gate insulating pattern GI, and the second separation insulating pattern 140. The upper insulating layer 130 may be on (e.g., may cover or overlap) top surfaces of the gate capping pattern GC, the gate insulating pattern GI, and the second separation insulating pattern 140.

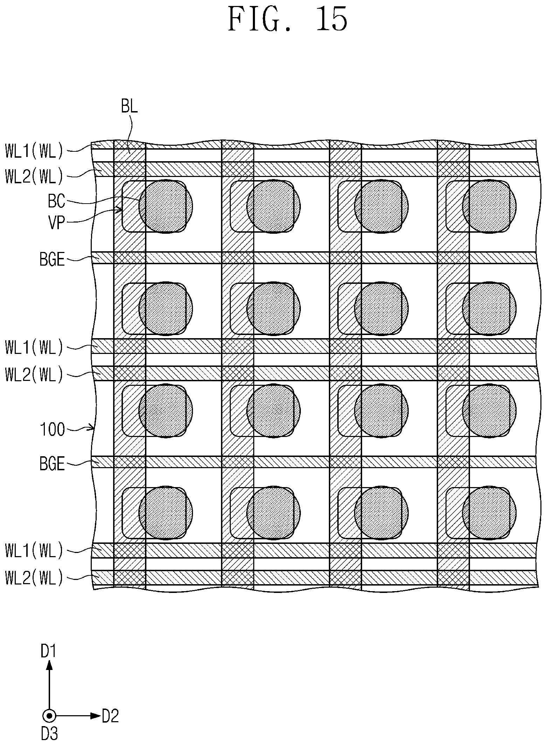

FIGS. 15 to 17 are plan views illustrating a semiconductor device according to some embodiments of the inventive concepts.

Referring to FIG. 15, the vertical portions VP of the semiconductor substrate 100 may have a non-rectangular shape, when viewed in a plan view. For example, the vertical portions VP may have a rectangle-like shape and may have rounded, rather than sharp, corners.

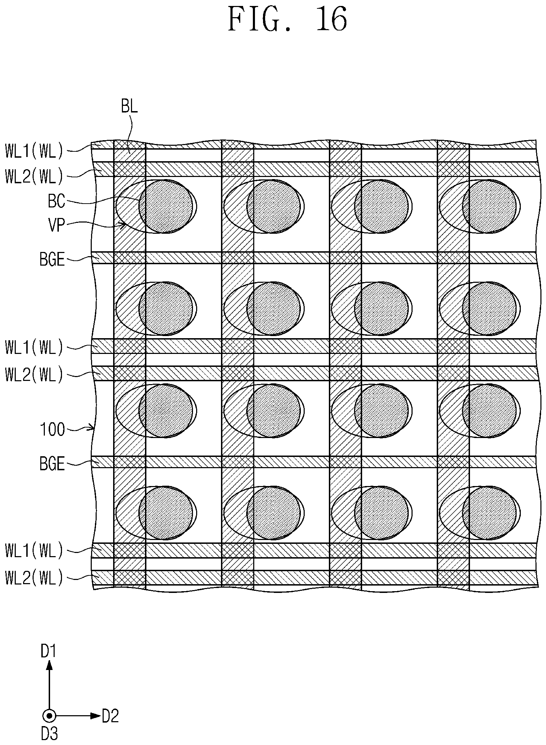

Referring to FIG. 16, the vertical portions VP of the semiconductor substrate 100 may have an elliptical shape, when viewed in a plan view. For example, the vertical portions VP may have an elliptical shape whose long and short axes are parallel to the second and first directions D2 and D1, but the inventive concepts are not limited to this example. For example, in some other embodiments, the vertical portions VP may have an ellipse shape, which has a long axis parallel to the first direction D1, or may have a circular shape.

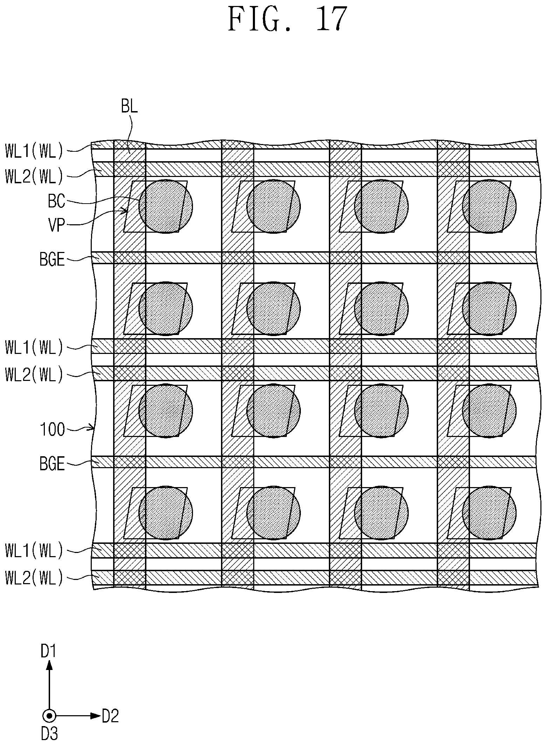

Referring to FIG. 17, the vertical portions VP of the semiconductor substrate 100 may have a parallelogram shape, when viewed in a plan view. For example, one of two pairs of parallel sides of the vertical portion VP may be parallel to the second direction D2, but the inventive concepts are not limited to this example.

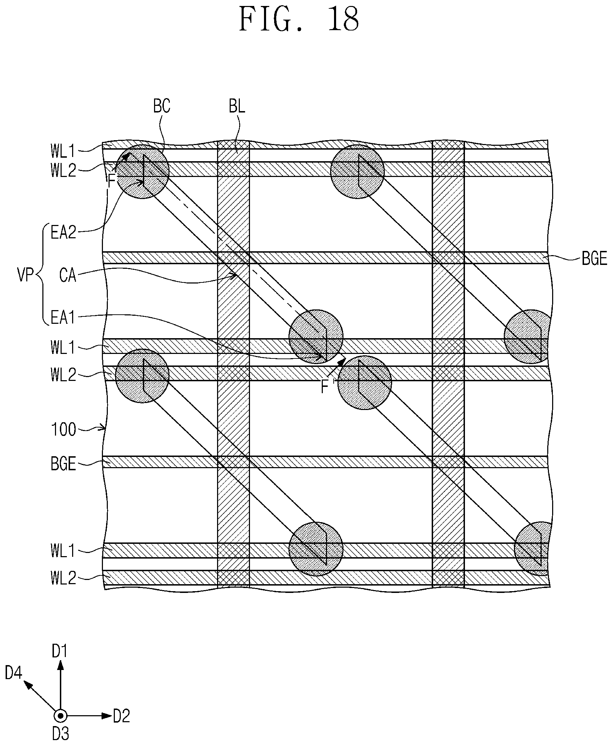

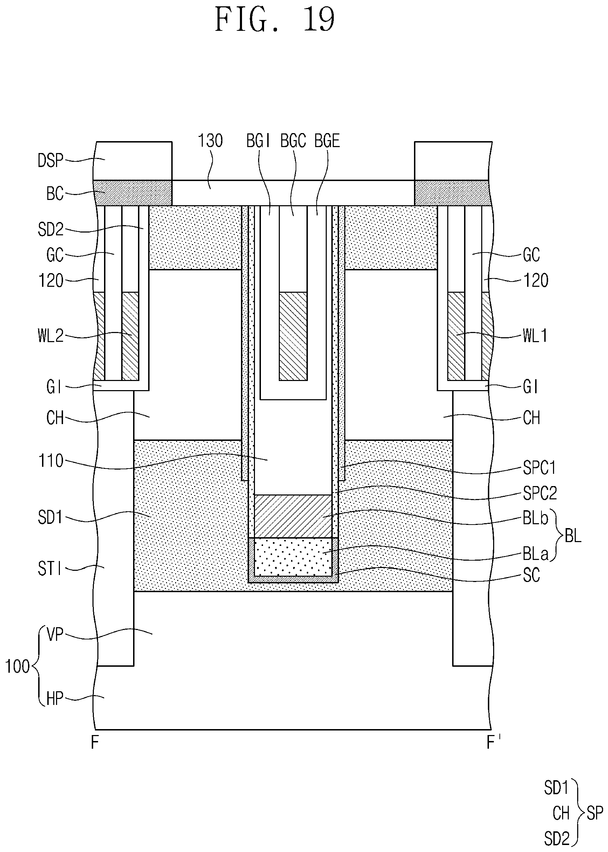

FIG. 18 is a plan view illustrating a semiconductor device according to some embodiments of the inventive concepts. FIG. 19 is a cross-sectional view taken along line F-F' of FIG. 18.

Referring to FIGS. 18 and 19, the vertical portions VP of the semiconductor substrate 100 may be extended in a fourth direction D4, which is perpendicular to the third direction D3 and is inclined at an acute angle to the first and second directions D1 and D2. For example, a longest dimension of each vertical portion VP may extend in the fourth direction D4, when viewed in a plan view. In some embodiments, each of the vertical portions VP may be a parallelogram shape elongated in the fourth direction D4 when viewed in a plan view, but the inventive concepts are not limited to this example. The vertical portions VP may be spaced apart from each other in the first and second directions D1 and D2.

Each of the vertical portions VP may include a first edge portion EA1 and a second edge portion EA2, which are spaced apart from each other in the fourth direction D4, and a center portion CA therebetween. The first and second edge portions EA1 and EA2 may be opposite end portions of the vertical portion VP in the fourth direction D4. The bit line BL may be provided on the center portion CA. For example, the bit line BL may overlap the center portion CA in the third direction D3. The word lines WL1 and WL2 may be provided to cross the first and second edge portions EA1 and EA2, respectively. When viewed in a plan view, the first word line WL1 may be provided to pass through the first edge portion EA1, and the second word line WL2 may be provided to pass through the second edge portion EA2. For example, the first word line WL1 may overlap the first edge portion EA1 in the third direction D3, and the second word line WL2 may overlap the second edge portion EA2 in the third direction D3.

The semiconductor patterns SP are disposed on the vertical portion VP and may be extended in the fourth direction D4. Each of the semiconductor patterns SP may include the first source/drain region SD1, the channel region CH, and the second source/drain region SD2, which are sequentially disposed in the third direction D3. The channel region CH may be provided between the first and second source/drain regions SD1 and SD2.

The semiconductor patterns SP include a semiconductor material. In some embodiments, the semiconductor patterns SP may include at least one of silicon (e.g., single crystalline silicon), germanium, or silicon-germanium. The first and second source/drain regions SD1 and SD2 may further include dopants. The first and second source/drain regions SD1 and SD2 may have the same conductivity type and may be impurity regions doped with n- or p-type dopants. The dopant concentration in the first and second source/drain regions SD1 and SD2 may be higher than the dopant concentration in the channel region CH.

The bit lines BL may be disposed on the semiconductor substrate 100. The bit lines BL may be extended in the first direction D1, on the vertical portions VP (in particular, the center portion CA), and may be spaced apart from each other in the second direction D2. Each of the bit lines BL may include the first bit line BLa and the second bit line BLb stacked on the first bit line BLa.

The bit lines BL may face a side surface of the first source/drain region SD1 of the semiconductor pattern SP. For example, the bit line BL may be adjacent to the side surface of the first source/drain region SD1 in the second direction D2. The top surface of the bit line BL may be located at a level lower than the uppermost end of the first source/drain region SD1.

The metal silicide pattern SC may be disposed between the bit line BL and the first source/drain region SD1 adjacent thereto. The metal silicide pattern SC may be in contact with the side and bottom surfaces of the first bit line BLa and the side surface of the first source/drain region SD1. Each of the metal silicide patterns SC may be disposed between the semiconductor pattern SP and the bit line BL and may be in contact with a side surface of the semiconductor pattern SP.

The gapfill insulating pattern 110 may be disposed on the bit line BL. The gapfill insulating pattern 110 may be on (e.g., may cover or overlap) the top surface of the bit line BL. In some embodiments, the gapfill insulating pattern 110 may include a silicon-based insulating material.

The first and second spacers SPC1 and SPC2 may be disposed on the side surfaces of the bit line BL and the gapfill insulating pattern 110. In more detail, a side surface of the second spacer SPC2 may be in contact with the side surface of the second bit line BLb and the side surface of the gapfill insulating pattern 110 in the second direction D2, and the first spacer SPC1 may be disposed on an opposite side surface of the second spacer SPC2. In other words, the first spacer SPC1 may be disposed between the second spacer SPC2 and the semiconductor pattern SP and may be spaced apart from the bit line BL.

The first spacer SPC1 may be in contact with the first source/drain region SD1, the channel region CH, and the second source/drain region SD2. The second spacer SPC2 may be in contact with the first spacer SPC1 and the first source/drain region SD1.

The word lines WL1 and WL2 may be disposed on the bit lines BL, the gapfill insulating pattern 110, and the device isolation layer STI and may cross the bit lines BL. The word lines WL1 and WL2 may be extended in the second direction D2 and may be spaced apart from each other in the first direction D1. The back gate electrodes BGE may be disposed on the gapfill insulating pattern 110 and the device isolation layer STI and over the bit lines BL to cross the bit lines BL. The back gate electrodes BGE may be extended in the second direction D2 and may be spaced apart from each other in the first direction D1. The word lines WL1 and WL2 and the back gate electrodes BGE may be spaced apart from each other in the first direction D1.

A corresponding pair of the word lines WL1 and WL2 may be disposed near both ends of each of the semiconductor patterns SP. For example, the second word line WL2 may be disposed near an end of the semiconductor pattern SP, and the first word line WL1 may be disposed near an opposite end of the semiconductor pattern SP. The back gate electrode BGE may be disposed between the first word line WL1 and the second word line WL2. The channel region CH of the semiconductor pattern SP may be placed between the first word line WL1 and the back gate electrode BGE and between the second word line WL2 and the back gate electrode BGE. The channel region CH of the semiconductor pattern SP may be controlled by corresponding ones of the first and second word lines WL1 and WL2.

The gate insulating pattern GI may be interposed between the semiconductor pattern SP and the corresponding one of the word lines WL and may be extended in the second direction D2. The back gate insulating pattern BGI may be interposed between the semiconductor pattern SP and the corresponding one of the back gate electrodes BGE and may be extended in the second direction D2.

The back gate electrode BGE may be configured to apply a voltage to a corresponding one of the semiconductor patterns SP. The applied voltage may be used to adjust a threshold voltage of the transistor including the semiconductor pattern SP, and thus, the transistor may be normally operated.

The upper conductive contacts BC may be disposed on the first and second edge portions EA1 and EA2, respectively. The upper conductive contacts BC may be spaced apart from each other in the fourth direction D4. The upper conductive contacts BC may be connected to the semiconductor patterns SP, respectively.

The data storage patterns DSP may be disposed on the upper conductive contacts BC, respectively, and may be spaced apart from each other in the fourth direction D4. The data storage patterns DSP may be electrically connected to the second source/drain regions SD2 of the semiconductor patterns SP, respectively, through the upper conductive contacts BC.

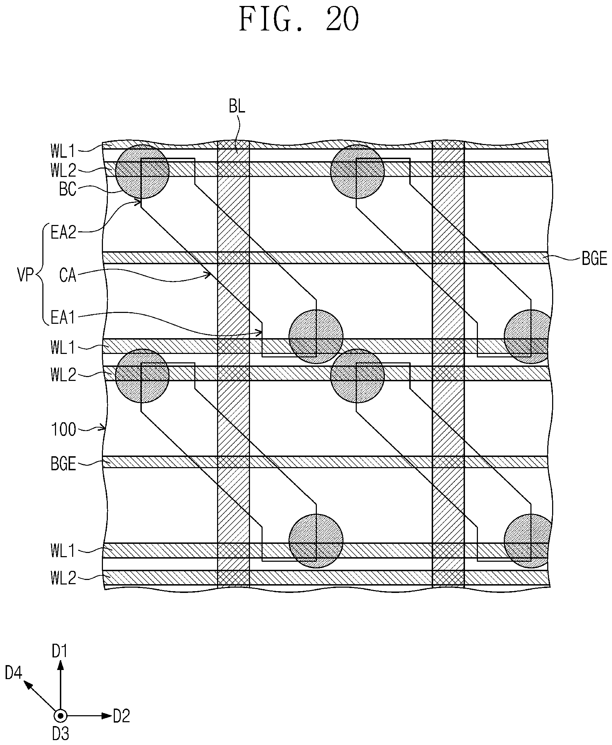

FIG. 20 is a plan view illustrating a semiconductor device according to some embodiments of the inventive concepts.

Referring to FIG. 20, the vertical portions VP of the semiconductor substrate 100 may have a non-parallelogram shape, when viewed in a plan view. For example, the center portion CA of the vertical portions VP may be extended in the fourth direction D4, and the first and second edge portions EA1 and EA2 may be extended in the first direction D1.

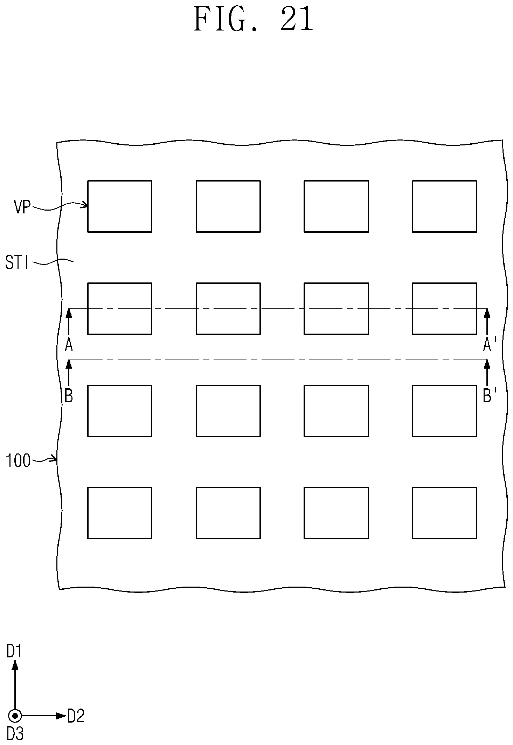

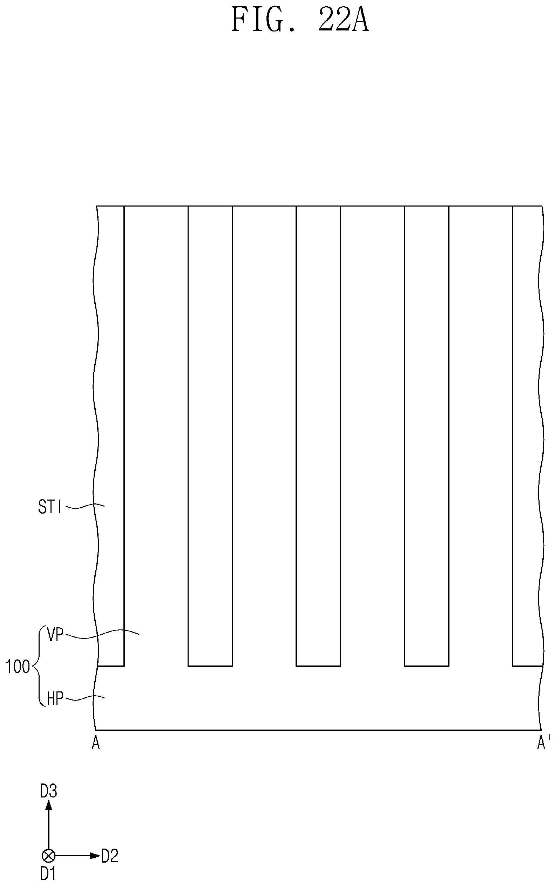

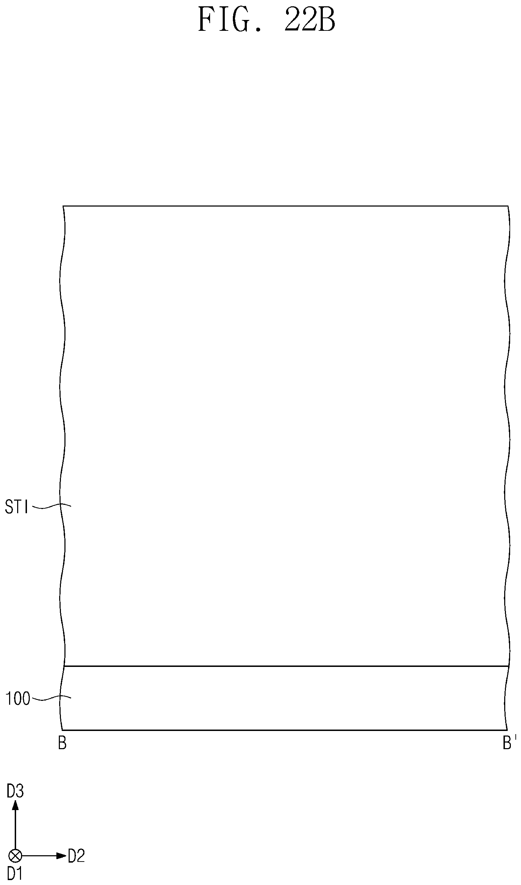

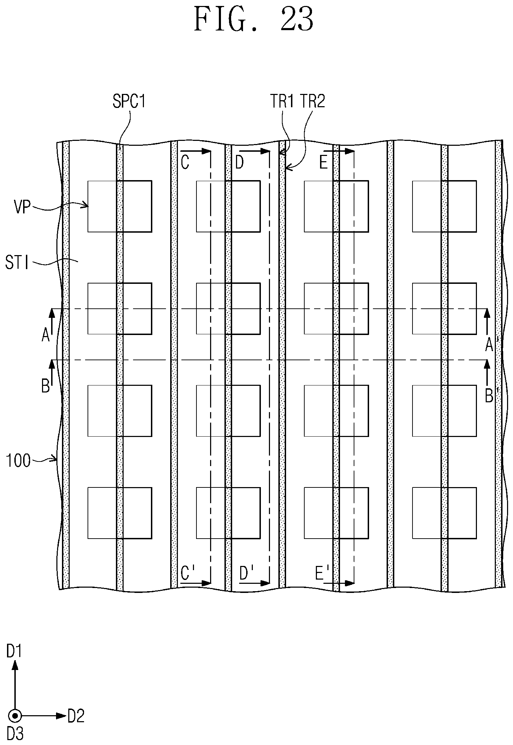

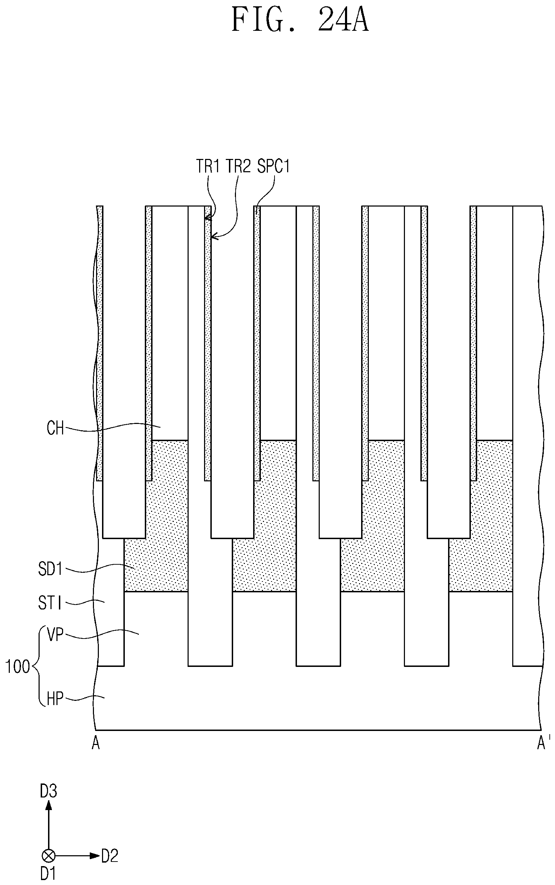

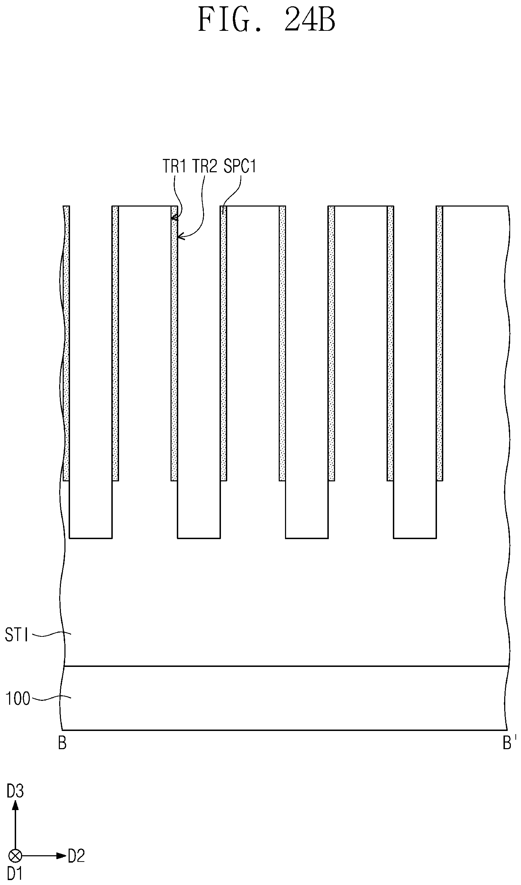

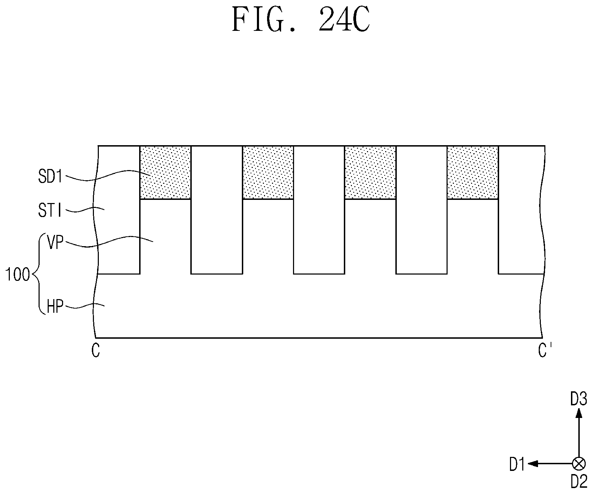

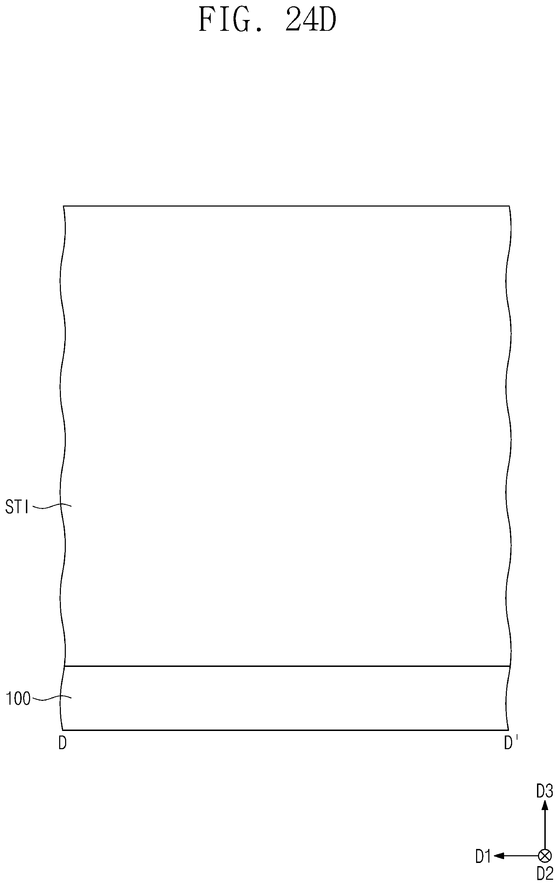

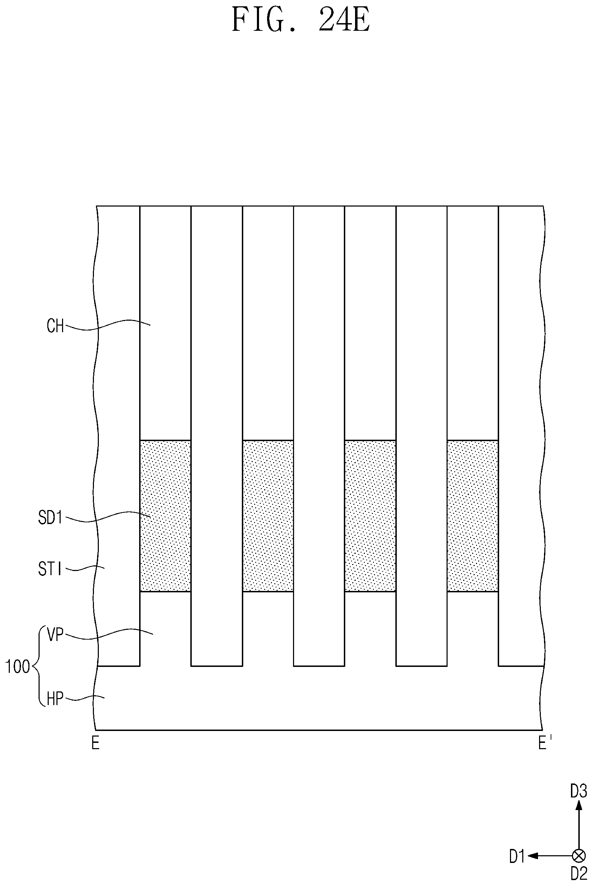

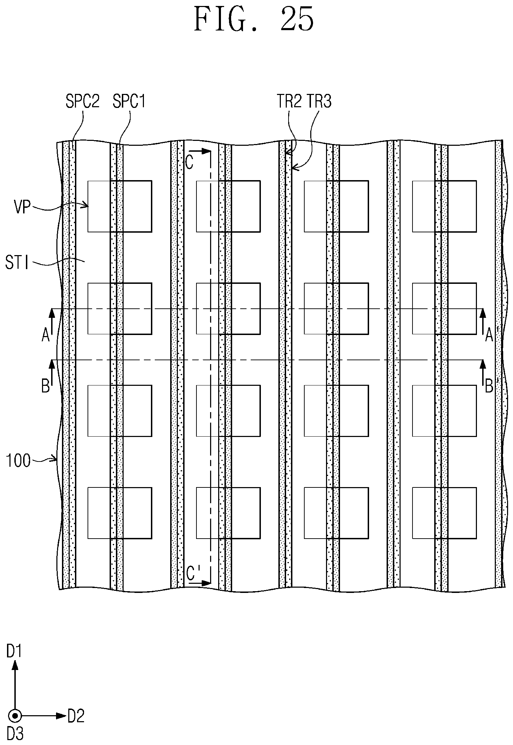

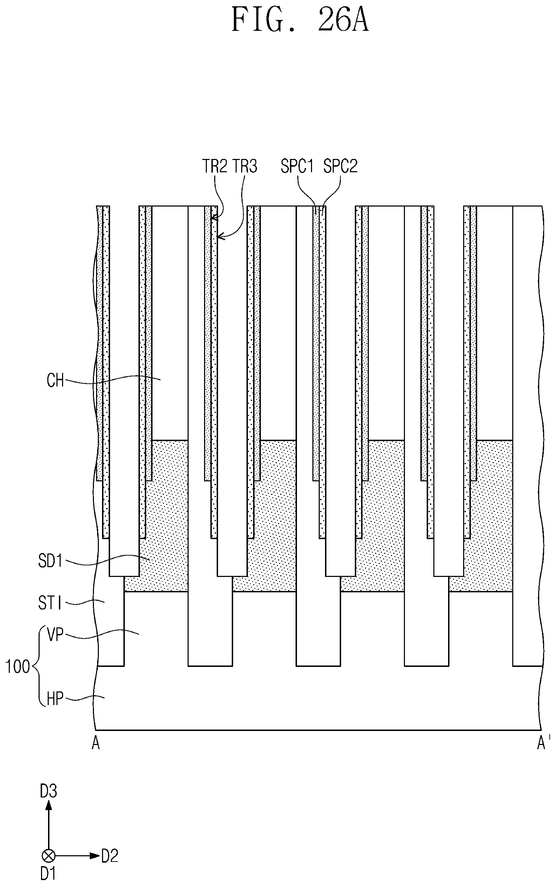

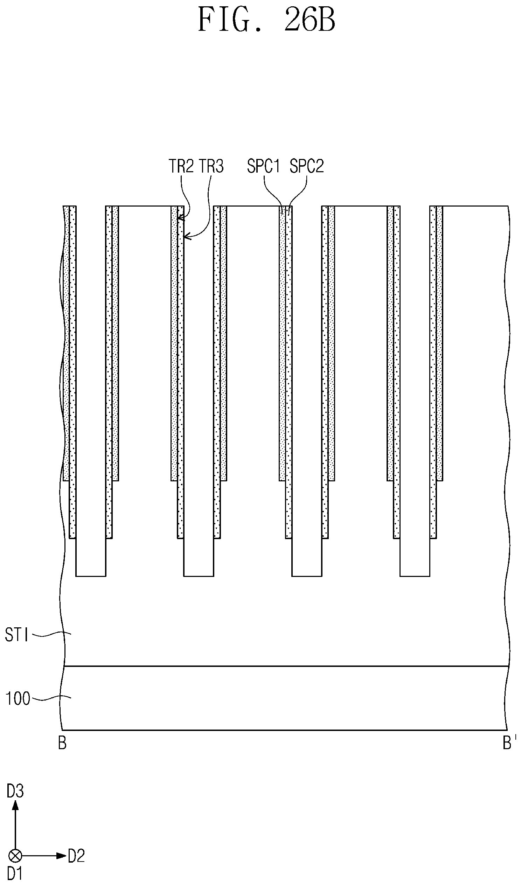

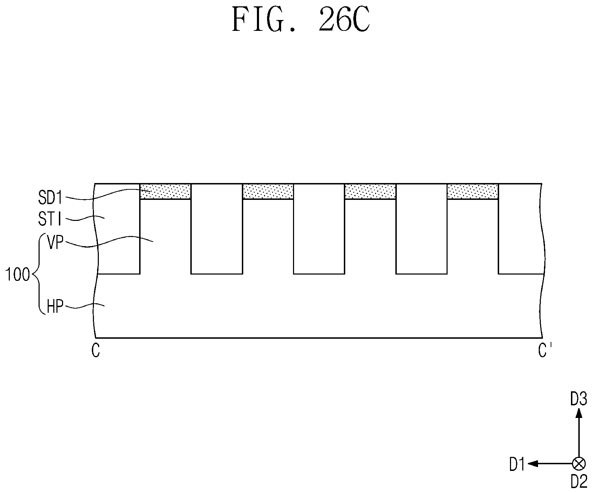

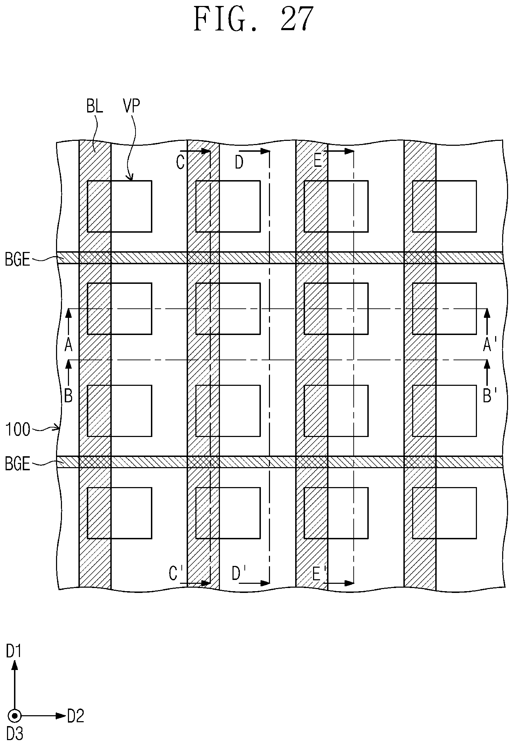

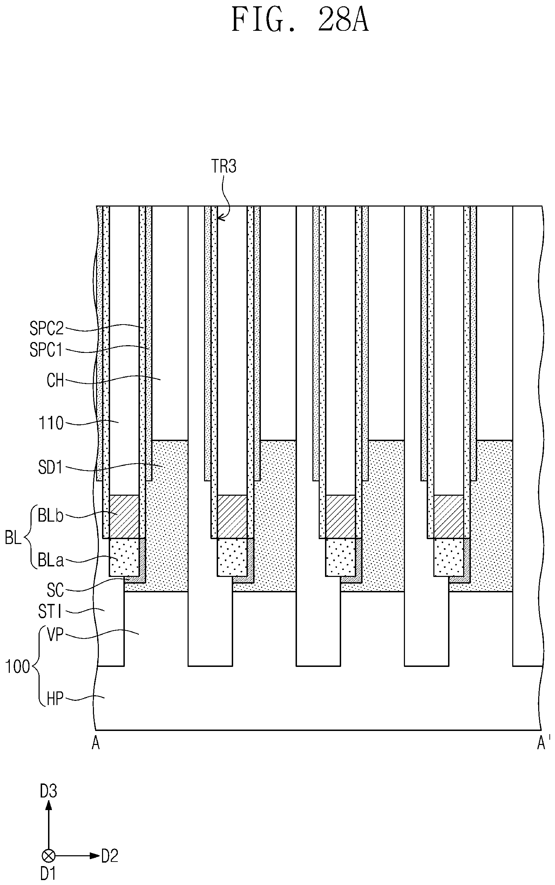

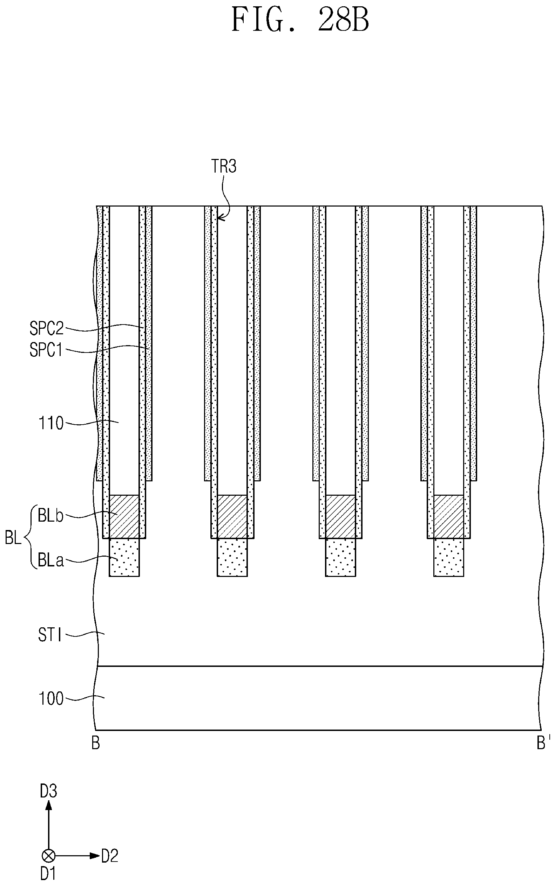

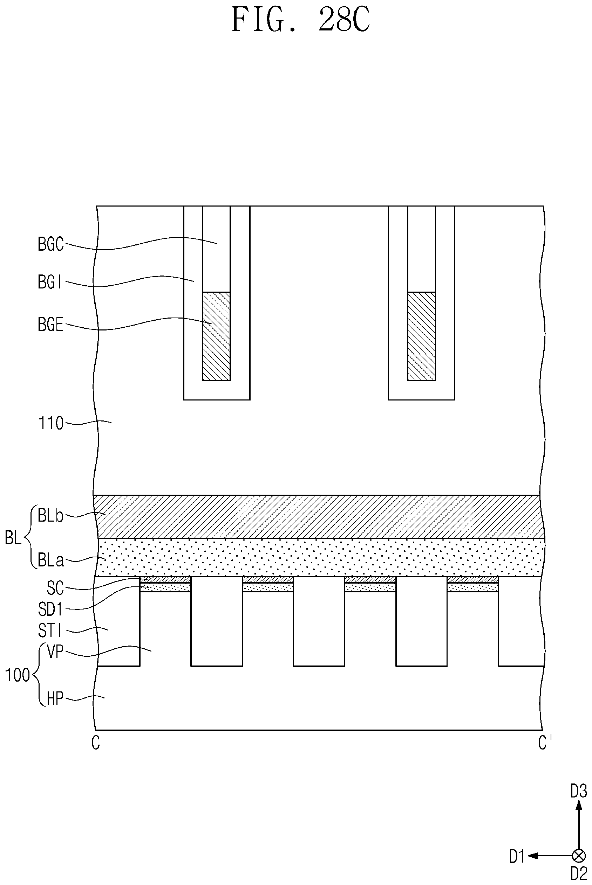

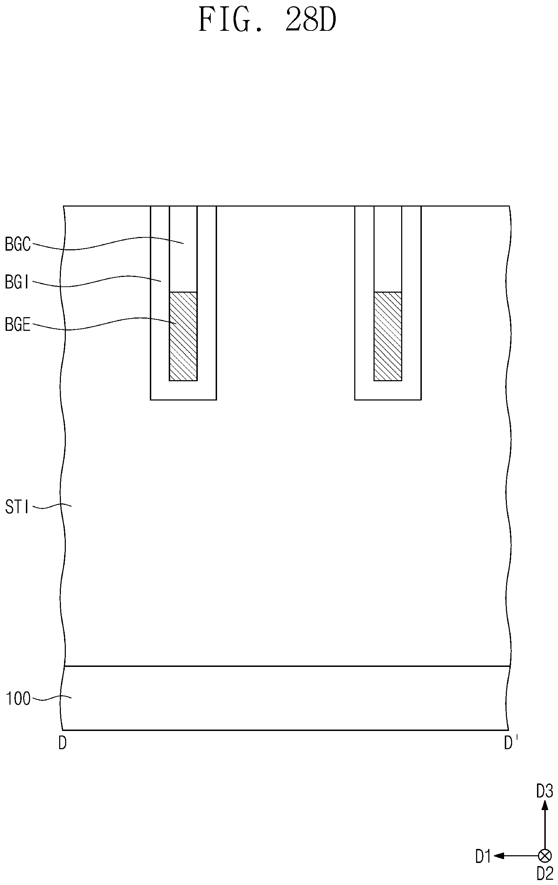

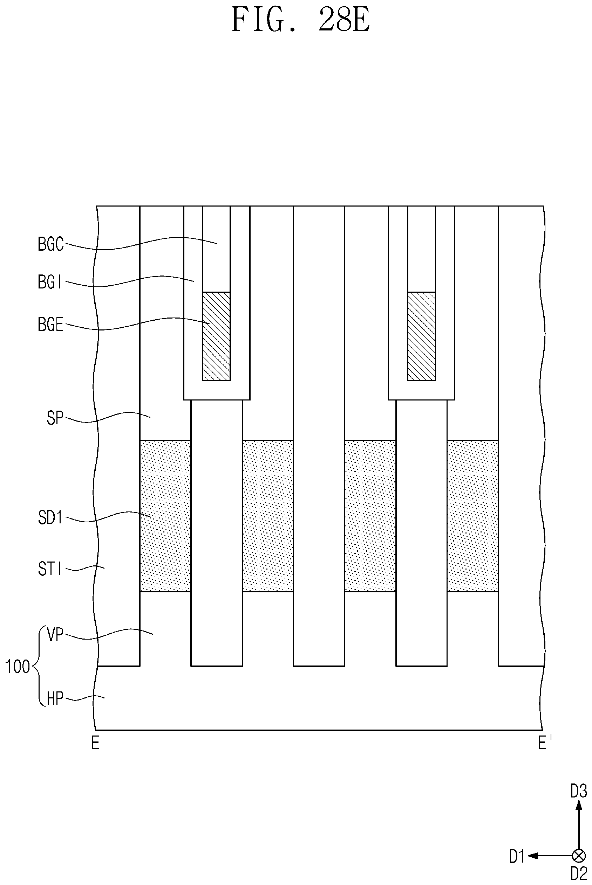

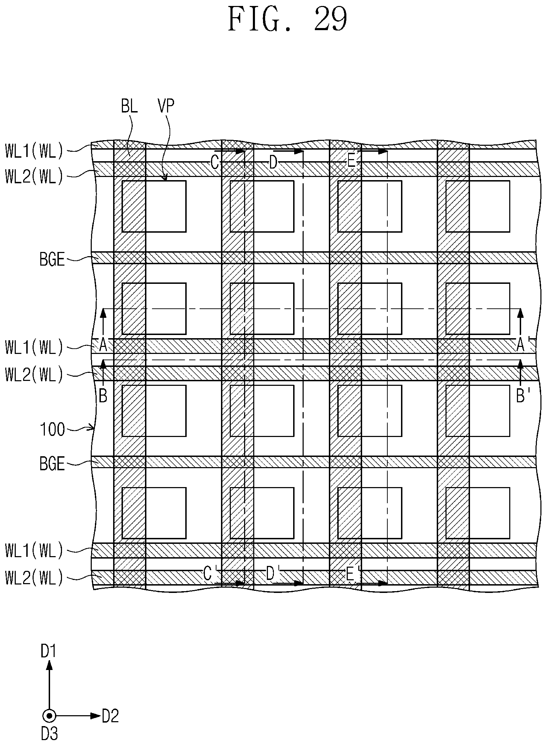

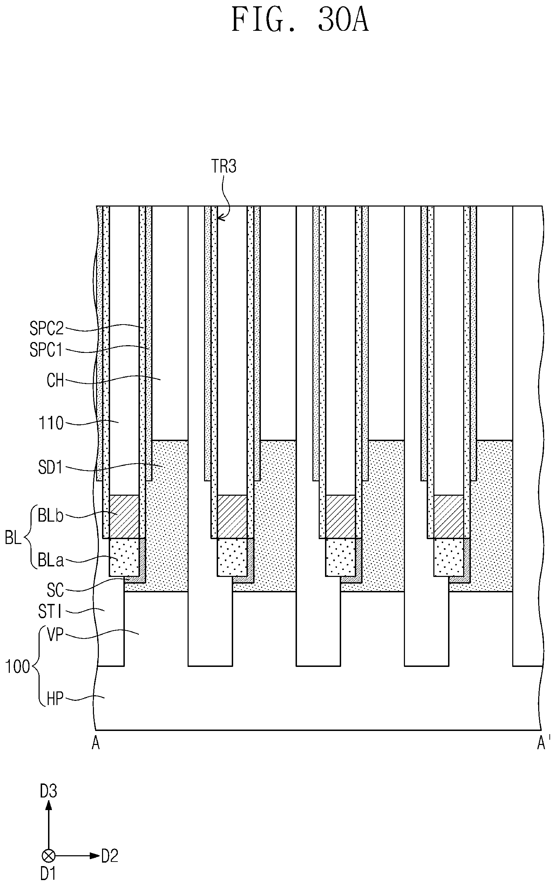

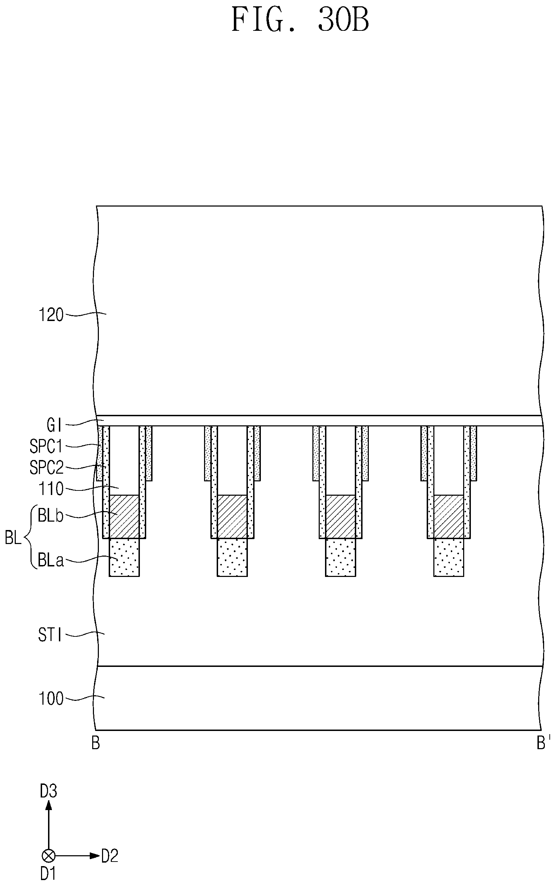

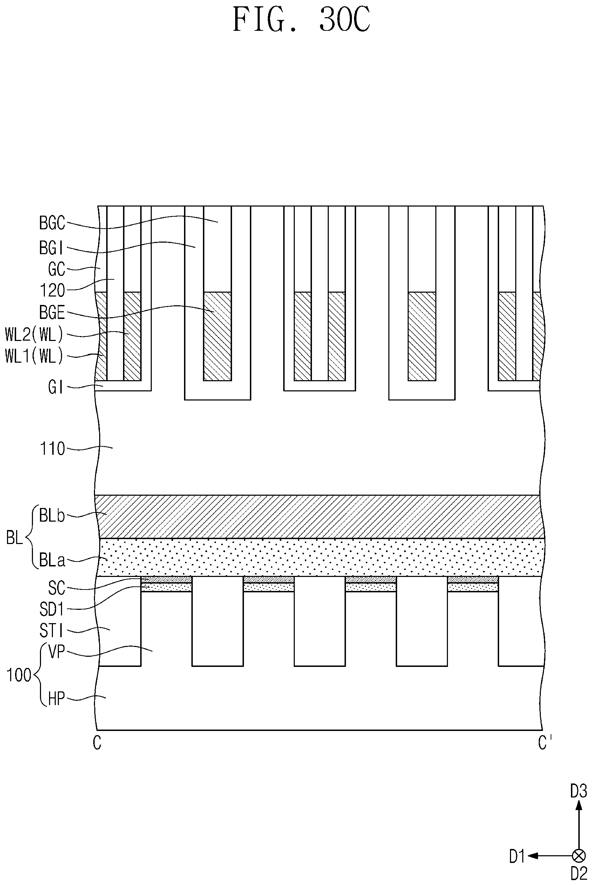

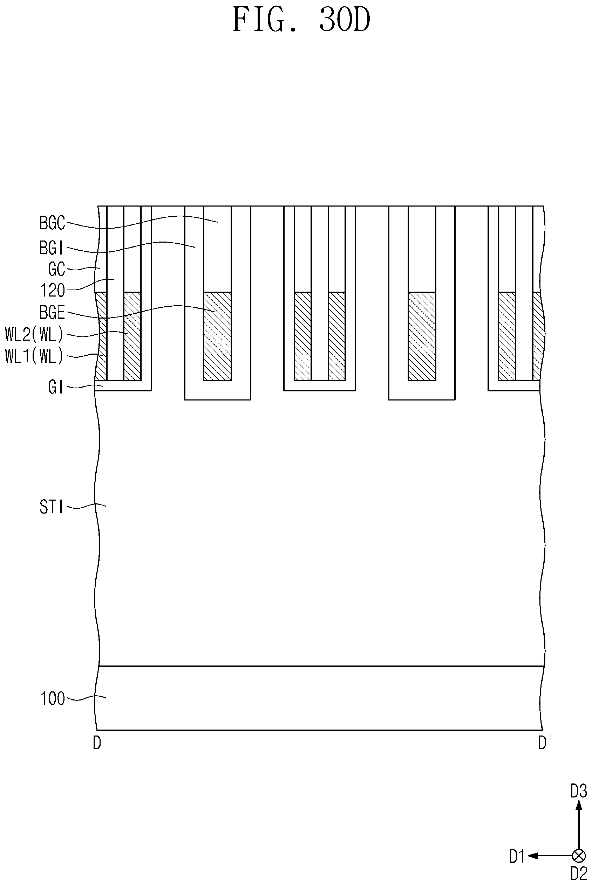

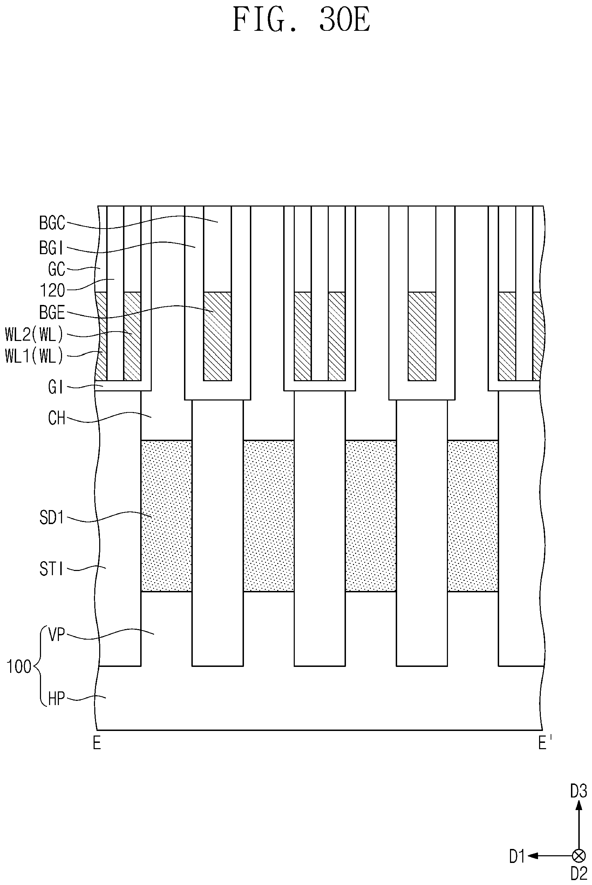

FIGS. 21, 22A, 22B, 23, 24A, 24B, 24C, 24D, 24E, 25, 26A, 26B, 26C, 27, 28A, 28B, 28C, 28D, 28E, 29, 30A, 30B, 30C, 30D, and 30E are diagrams illustrating a method of fabricating a semiconductor device, according to some embodiments of the inventive concepts. In particular, FIGS. 21, 23, 25, 27, and 29 are plan views illustrating a semiconductor device according to some embodiments of the inventive concepts. FIGS. 22A and 22B are cross-sectional views taken along lines A-A' and B-B', respectively, of FIG. 21. FIGS. 24A to 24E are cross-sectional views taken along lines A-A', B-B', C-C', D-D', and E-E', respectively, of FIG. 23. FIGS. 26A to 26C are cross-sectional views taken along lines A-A', B-B', and C-C', respectively, of FIG. 25. FIGS. 28A to 28E are cross-sectional views taken along lines A-A', B-B', C-C', D-D', and E-E', respectively, of FIG. 27. FIGS. 30A to 30E are cross-sectional views taken along lines A-A', B-B', C-C', D-D', and E-E', respectively, of FIG. 29. For the sake of brevity, an element previously described with reference to FIGS. 4 and 5A to 5E may be identified by the same reference number without repeating an overlapping description thereof.

Referring to FIGS. 21, 22A, and 22B, the semiconductor substrate 100 may be provided. The semiconductor substrate 100 may be patterned in the first and second directions D1 and D2 to form the horizontal portion HP and the vertical portions VP, which are extended upward from the horizontal portion HP. The vertical portions VP may be portions of the semiconductor substrate 100 protruding in the third direction D3. In other words, top surfaces of the vertical portions VP may be located at a level higher than a top surface of the horizontal portion HP. The vertical portions VP may be spaced apart from each other in the first and second directions D1 and D2. In some embodiments, the vertical portions VP may have the shape of a rectangular pillar. In some embodiments, the semiconductor substrate 100 may be a silicon substrate.

The device isolation layer STI may be formed on the horizontal portion HP. The device isolation layer STI may be on (e.g., may cover or overlap) the horizontal portion HP and may be in (e.g., may fill) a space between the vertical portions VP. In some embodiments, the device isolation layer STI may include at least one of silicon oxide or silicon nitride.

Referring to FIGS. 23 and 24A to 24E, the device isolation layer STI and the vertical portions VP may be partially patterned to form first trenches TR1. The first trenches TR1 may be extended in the first direction D1 and may be spaced apart from each other in the second direction D2. First spacer layers may be formed to conformally extend on (e.g., to conformally cover) inner surfaces of the first trenches TR1, respectively.

Second trenches TR2 may be formed by patterning the first spacer layer, the device isolation layer STI, and the vertical portion VP in each of the first trenches TR1. The second trenches TR2 may be extended in the first direction D1 and may be spaced apart from each other in the second direction D2. During the formation of the second trenches TR2, the first spacer layer may be partially removed to form a pair of first spacers SPC1, which are spaced apart from each other in the second direction D2. In addition, the second trenches TR2 may be formed to partially expose side surfaces of the vertical portions VP.

Dopants (e.g., n- or p-type dopants) may be injected into the exposed side surfaces of the vertical portions VP. In some embodiments, the dopants may be injected into the vertical portions VP using at least one of an ion injection method, a plasma doping method, or a gas doping method. Since the dopants are injected into the vertical portions VP, the first source/drain regions SD1 including the dopants may be formed in the vertical portions VP. The first source/drain regions SD1 may be formed in portions of the vertical portions VP, which are exposed through the second trenches TR2. Portions of the vertical portions VP, which are located on (e.g., above) the first source/drain regions SD1, may be referred to as the channel regions CH.

According to some embodiments of the inventive concepts, portions of the first source/drain regions SD1 may be additionally etched. For example, side surfaces of the first source/drain regions SD1 may be etched through a wet etching process, and thus, inner surfaces of the first source/drain regions SD1 may have a rounded shape (e.g., see FIG. 6).

Referring to FIG. 25 and FIGS. 26A to 26C, second spacer layers may be formed to conformally extend on (e.g., to conformally cover) inner surfaces of the second trenches TR2, respectively. Next, third trenches TR3 may be formed by patterning the second spacer layer, the device isolation layer STI, and the first source/drain region SD1 in each of the second trenches TR2. The third trenches TR3 may be extended in the first direction D1 and may be spaced apart from each other in the second direction D2. During the formation of the third trenches TR3, the second spacer layer may be partially removed to form a pair of second spacers SPC2, which are spaced apart from each other in the second direction D2. In addition, the side surfaces of the first source/drain regions SD1 may be partially exposed through the third trenches TR3.

According to some other embodiments of the inventive concepts, the formation of the third trenches TR3 may be omitted. For example, the second spacer layer may be formed to be on (e.g., to cover or overlap) the inner surfaces of the second trenches TR2, and a bottom portion of the second spacer layer may be removed to expose the first source/drain regions SD1 and the device isolation layers STI. A selective epitaxial growth (SEG) process may be performed on the first source/drain region SD1. Thus, epitaxial patterns may be formed on the device isolation layer STI and the first source/drain region SD1. In some embodiments, the epitaxial growth process may include a chemical vapor deposition (CVD) process or a molecular beam epitaxy (MBE) process. Next, a bit line forming process, which will be described below, may be performed on the epitaxial pattern (e.g., see FIG. 7).

Referring to FIG. 27 and FIGS. 28A to 28E, the first bit lines BLa may be formed on inner surfaces of the third trenches TR3, respectively. The first bit lines BLa may be formed to be in contact with the exposed side surfaces of the first source/drain regions SD1, respectively. Next, an annealing process may be performed to diffuse the first metal element of the first bit lines BLa into the first source/drain regions SD1, thereby forming the metal silicide pattern SC. The metal silicide pattern SC may be formed between the first bit line BLa and the first source/drain region SD1.

The second bit lines BLb may be formed on the first bit lines BLa, respectively. The second bit lines BLb may be formed in the second trenches TR2. Thereafter, the gapfill insulating patterns 110 may be formed on the second bit lines BLb, respectively. The gapfill insulating patterns 110 may be in (e.g., may fill) inner spaces of the second trenches TR2.

The back gate insulating patterns BGI, the back gate electrodes BGE, and the back gate capping patterns BGC may be formed on the gapfill insulating pattern 110 and the device isolation layer STI. The formation of the back gate insulating pattern BGI may include patterning the gapfill insulating pattern 110 and the device isolation layer STI to form a trench and depositing an insulating material to conformally extend on (e.g., to conformally cover) an inner surface of the trench. The trench may be extended in the second direction D2.

In some embodiments, the formation of the back gate electrode BGE may include forming a back gate electrode layer in the trench and on the back gate insulating pattern BGI and performing an etch-back process on the back gate electrode layer. The back gate capping pattern BGC may be in (e.g., may fill) a remining portion of the trench, which is located on the back gate electrode BGE.

According to some embodiments of the inventive concepts, the bit line BL may be buried in a region between the semiconductor patterns SP, which are placed on a top surface of the semiconductor substrate 100. That is, in the process of fabricating a semiconductor device, the bit line BL may be formed on the top surface of the semiconductor substrate 100, not on the bottom surface of the semiconductor substrate 100. Accordingly, an additional bonding process may not be required to connect the bit line BL to the semiconductor substrate 100. Thus, the bonding process, which is performed at a high temperature, may be omitted, and the semiconductor device may not be exposed to the high temperature environment. This may make it possible to improve the electric reliability of the semiconductor device.

Referring to FIG. 29 and FIGS. 30A to 30E, the gate insulating patterns GI, the word lines WL, the gate capping patterns GC, and the separation insulating patterns 120 may be formed.

The formation of the gate insulating patterns GI may include patterning the gapfill insulating pattern 110 and the device isolation layer STI to form a trench and depositing an insulating material to conformally extend on (e.g., to conformally cover) an inner surface of the trench. The trench may be extended in the second direction D2.

The word lines WL may be formed to be in (e.g., to fill) a portion of the trench. In some embodiments, the formation of the word lines WL may include forming a gate electrode layer on the gate insulating pattern GI in the trench and performing an etch-back process on the gate electrode layer. The gate capping pattern GC may be formed on the word lines WL to be in (e.g., to fill) a remaining portion of the trench.

The separation insulating pattern 120 may be formed in the trench provided with the word lines WL. The separation insulating pattern 120 may be formed to penetrate the gate capping pattern GC and the word line WL and may be extended in the second direction D2. The word line WL may be divided into a pair of word lines WL1 and WL2, which are spaced apart from each other in the first direction D1, by the separation insulating pattern 120. The gate capping patterns GC may be spaced apart from each other in the first direction D1 by the separation insulating pattern 120.

Referring back to FIG. 4 and FIGS. 5A to 5E, upper portions of the semiconductor patterns SP may be doped with dopants. The second source/drain regions SD2 may be formed in the upper portions of the semiconductor patterns SP, respectively.

The upper insulating layer 130 may be formed to be on (e.g., to cover or overlap) the gate capping pattern GC, the gate insulating pattern GI, the separation insulating pattern 120, the back gate capping pattern BGC, the back gate insulating pattern BGI, and the semiconductor patterns SP.

The upper conductive contacts BC may be formed in the upper insulating layer 130. The upper conductive contacts BC may be spaced apart from each other in the first and second directions D1 and D2. The upper conductive contacts BC may be formed to penetrate the upper insulating layer 130 and may be connected to the semiconductor patterns SP, respectively. In some embodiments, the formation of the upper conductive contacts BC may include forming upper contact holes to penetrate the upper insulating layer 130 and expose the semiconductor patterns SP, forming an upper contact layer on the upper insulating layer 130 to be in (e.g., to fill) the upper contact holes, and planarizing the upper contact layer to expose a top surface of the upper insulating layer 130. As a result of the planarization process, the upper conductive contacts BC may be locally formed in the upper contact holes, respectively.

The data storage patterns DSP may be formed on the upper conductive contacts BC, respectively. In some embodiments, the formation of the data storage patterns DSP may include forming a data storing layer on the upper insulating layer 130 and patterning the data storing layer.

According to example embodiments of the inventive concepts, a bit line may be buried between semiconductor patterns, which are placed on a top surface of a semiconductor substrate, thereby facing a side surface of a first source/drain region. Since, in the process of fabricating a semiconductor device, the bit line is formed on the top surface of the semiconductor substrate, it may be possible to omit steps of forming the bit line on a rear surface of the semiconductor substrate and performing an additional bonding process. Thus, the bonding process, which is performed at a high temperature, may be omitted, and the semiconductor device may not be exposed to the high temperature environment. This may make it possible to improve the electric reliability of the semiconductor device.

While example embodiments of the inventive concepts have been particularly shown and described, it will be understood by one of ordinary skill in the art that variations in form and detail may be made therein without departing from the scope of the attached claims.

As used herein, the terms "comprises", "comprising", "includes", "including", "has", "having" and any other variations thereof specify the presence of the stated features, steps, operations, elements, components, and/or groups but do not preclude the presence or addition of one or more other features, steps, operations, elements, components, and/or groups thereof. In addition, it will be understood that, although the terms "first", "second", "third", etc. may be used herein to describe various elements, these elements should not be limited by these terms. Rather, these terms are only used to distinguish one element from another. For example, a first element could be termed a second element, and, similarly, a second element could be termed a first element, without departing from the scope of the present disclosure. Further, as used herein, the term "and/or" includes any and all combinations of one or more of the associated listed items.

## Claims

1. A semiconductor device, comprising:
a semiconductor substrate (100) including a horizontal portion (HP) and a vertical portion (VP) protruding upward from the horizontal portion;
a bit line (BL) on the semiconductor substrate and extending in a first direction (D1) parallel to a bottom surface of the semiconductor substrate;
a word line on the bit line and extending in a second direction parallel to the bottom surface of the semiconductor substrate that is different from the first direction;
a semiconductor pattern (SP) on the vertical portion of the semiconductor substrate and extending in a third direction perpendicular to the bottom surface of the semiconductor substrate; and
a metal silicide pattern (SC) between the semiconductor pattern and the bit line,
wherein the semiconductor pattern comprises a source/drain region adjacent to the bit line and a channel region on the source/drain region, and
wherein the metal silicide pattern is in contact with the source/drain region and the bit line.

2. The semiconductor device of claim 1, wherein the metal silicide pattern is in contact with a side surface of the source/drain region, wherein the bit line comprises a first bit line and a second bit line on the first bit line, and wherein the metal silicide pattern is in contact with a side surface of the first bit line.

3. The semiconductor device of claim 2, wherein each of the first bit line and the metal silicide pattern comprises a metal material.

4. The semiconductor device of claim 1, 2 or 3, further comprising:
a first spacer on a side surface of the semiconductor pattern; and
a second spacer on a side surface of the first spacer,
wherein the bit line is in contact with the second spacer.

5. The semiconductor device of any one of claims 1 to 4, wherein the source/drain region has a curved side surface, and wherein the metal silicide pattern is on the curved side surface of the source/drain region.

6. The semiconductor device of any one of claims 1 to 5, further comprising a device isolation layer on the horizontal portion of the semiconductor substrate, wherein a bottom surface of the metal silicide pattern is in contact with the device isolation layer and the source/drain region.

7. The semiconductor device of any one of claims 1 to 6, further comprising a back gate electrode spaced apart from the word line in the first direction and extending in the second direction, wherein the channel region is between the back gate electrode and the word line.

8. The semiconductor device of any one of claims 1 to 7, further comprising a gate insulating pattern between the word line and the semiconductor pattern, wherein the word line and the gate insulating pattern at least partially surround a portion of the semiconductor pattern.

9. The semiconductor device of any one of claims 1 to 8, further comprising:
an upper insulating layer on the word line;
an upper conductive contact extending in the upper insulating layer and electrically connected to the semiconductor pattern; and
a data storage pattern electrically connected to the upper conductive contact.

10. The semiconductor device of any one of claims 1 to 9, wherein a first distance in the third direction between the bottom surface of the semiconductor substrate and a top surface of the bit line is less than a second distance in the third direction between the bottom surface of the semiconductor substrate and an uppermost end of the source/drain region.

11. The semiconductor device of any one of claims 1 to 10, comprising:
a semiconductor substrate including a horizontal portion and a vertical portion protruding upward from the horizontal portion;
a bit line on the semiconductor substrate and extending in a first direction parallel to a bottom surface of the semiconductor substrate;
a word line on the bit line and extending in a second direction parallel to the bottom surface of the semiconductor substrate that is different from the first direction;
a back gate electrode spaced apart from the word line in the first direction and extending in the second direction; and
a semiconductor pattern on the vertical portion of the semiconductor substrate and extending in a third direction perpendicular to the bottom surface of the semiconductor substrate,
wherein the semiconductor pattern comprises a first source/drain region, a channel region, and a second source/drain region stacked in the third direction,
wherein the bit line is adjacent to a side surface of the first source/drain region in the second direction, and
wherein the channel region is between the word line and the back gate electrode.

12. The semiconductor device of claim 11, further comprising:
a gate capping pattern on the word line; and
a back gate capping pattern on the back gate electrode,
wherein the second source/drain region is between the gate capping pattern and the back gate capping pattern.

13. The semiconductor device of claim 11 or 12, wherein a first distance in the third direction between the bottom surface of the semiconductor substrate and a top surface of the bit line is less than a second distance in the third direction between the bottom surface of the semiconductor substrate and an uppermost end of the first source/drain region.

14. The semiconductor device of claim 11, 12, or 13, further comprising:
a first spacer on a side surface of the semiconductor pattern; and
a second spacer on a side surface of the first spacer,
wherein the bit line is spaced apart from the first spacer and is in contact with the second spacer.

15. The semiconductor device of any one of claims 11 to 14, further comprising:
a gate insulating pattern between the semiconductor pattern and the word line; and
a back gate insulating pattern between the semiconductor pattern and the back gate electrode.
